(19) Europäisches Patentamt
European Patent Office
Office européen des brevets

(11) EP 1 950 594 A1

(12) **EUROPÄISCHE PATENTANMELDUNG**

(43) Veröffentlichungstag:
**30.07.2008 Patentblatt 2008/31**

(21) Anmeldenummer: **08000196.9**

(22) Anmeldetag: **08.01.2008**

(51) Int Cl.:
*G02B 17/06* (2006.01)   *G03F 7/20* (2006.01)
*G02B 27/00* (2006.01)

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **17.01.2007 DE 102007003305**

(71) Anmelder: **Carl Zeiss SMT AG**
**73447 Oberkochen (DE)**

(72) Erfinder: **Mann, Hans-Jürgen, Dr.**
**73447 Oberkochen (DE)**

(74) Vertreter: **Hofmann, Matthias et al**
**Rau, Schneck & Hübner**
**Patentanwälte**
**Königstrasse 2**
**90402 Nürnberg (DE)**

(54) **Abbildende Optik, Projektionsbelichtunsanlage für die Mikrolithographie mit einer derartigen abbildenden Optik, Verfahren zur Herstellung eines mikrostrukturierten Bauteils mit einer derartigen Projektionsbelichtungsanlage, durch das Herstellungsverfahren gefertigtes mikrostrukturiertes Bauelement sowie Verwendung einer derartigen abbildenden Optik**

(57) Eine Projektionsbelichtungsanlage für die Mikrolithografie hat eine abbildende Optik (6) mit einer Mehrzahl von Spiegeln (M1 bis M6). Letztere bilden ein Objektfeld in einer Objektebene (4) in ein Bildfeld in einer Bildebene (8) ab. Einer der Spiegel (M6) hat eine Durchgangsöffnung (23) zum Durchtritt des Abbildungslichts (3). Eine Reflexionsfläche mindestens eines Spiegels (M1 bis M6) ist als nicht durch eine rotationssymmetrische Funktion beschreibbare Freiformfläche ausgeführt. Die Projektionsbelichtungsanlage hat zudem eine Lichtquelle für das Beleuchtungs- und Abbildungslicht (3) und eine Beleuchtungsoptik zur Führung des Beleuchtungslichts (3) hin zum Objektfeld der abbildenden Optik (6). Mit der Projektionsbelichtungsanlage wird durch Bereitstellung eines Retikels und eines Wafers sowie durch Projizieren einer Struktur auf dem Retikel auf eine lichtempfindliche Schicht des Wafers und Erzeugung einer Mikrostruktur auf dem Wafer ein mikrostrukturiertes Bauteil hergestellt. Eine entsprechende abbildende Optik, bei der Objekt- und Bildebene vertauscht sind, kann als Mikroskopobjektiv verwendet werden. Es resultiert eine abbildende Optik mit verbesserten Abbildungseigenschaften und/oder einfacherer Herstellbarkeit der Spiegel bei vorgegebener Baugröße.

Fig. 2

EP 1 950 594 A1

**Beschreibung**

Die Erfindung betrifft eine abbildende Optik nach dem Oberbegriff des Anspruchs 1. Ferner betrifft die Erfindung eine Projektionsbelichtungsanlage mit einer derartigen abbildenden Optik, ein Verfahren zur Herstellung eines mikrostrukturierten Bauteils mit einer derartigen Projektionsbelichtungsanlage, ein mit diesem Verfahren hergestelltes mikrostrukturiertes Bauelement sowie eine Verwendung der abbildenden Optik.

Abbildende Optiken der eingangs genannten Art sind einerseits bekannt als Projektionsoptiken als Bestandteil von Projektionsbelichtungsanlagen für die Mikrolithografie. Beispiele hierfür geben die EP 1093 021 A2 und die DE 10 2005 042 005 A1. Eine abbildende Optik mit Spiegeln, die in aufeinander senkrecht stehenden Hauptebenen unterschiedliche Krümmungsradien aufweisen, ist bekannt aus der US 2006/0284113 A1. Ferner ist eine abbildende Optik der eingangs genannten Art bekannt im Zusammenhang mit einem Mikroskopobjektiv zur Inspektion von Masken oder Wafern. Ein Beispiel hierfür gibt die US 6 894 834 B2.

Sowohl was die Verwendung innerhalb einer Projektionsbelichtungsanlage angeht als auch was die Verwendung als Mikroskopobjektiv angeht, besteht für die abbildende Optik der eingangs genannten Art der Bedarf nach verbesserten Abbildungseigenschaften, zum Beispiel einer größeren Apertur oder einer besseren Korrektur von Abbildungsfehlern. Alternativ oder zusätzlich besteht der Bedarf nach einfacherer Herstellbarkeit der Spiegel bei vorgegebener Baugröße, wobei insbesondere für Systeme bei EUV-Wellenlängen ein hoher Lichtdurchsatz erzielt werden soll.

Diese Aufgabe ist erfindungsgemäß gelöst durch eine abbildende Optik mit den im Kennzeichnungsteil des Anspruchs 1 angegebenen Merkmalen.

Erfindungsgemäß wurde erkannt, dass der Einsatz von Freiformflächen anstelle von eine Rotationssymmetrieachse aufweisenden Reflexionsflächen neue Designsfreiheitsgrade schafft, was zu abbildenden Optiken mit Eigenschaftskombinationen führt, die mit rotationssymmetrischen Reflexionsflächen nicht realisierbar waren. Die Freiformfläche ist nicht durch eine Funktion beschreibbar, die um eine ausgezeichnete Achse, die eine Normale zu einem Flächenabschnitt der optischen Fläche darstellt, rotationssymmetrisch ist. Die erfindungsgemäße Freiformfläche ist also insbesondere nicht durch eine Kegelschnitt-Asphärengleichung beschreibbar. Derartige Asphären weichen zwar von einer sphärischen Symmetrie ab, sind aber durch eine rotationssymmetrische Funktion beschreibbar, nämlich durch eine Funktion, die lediglich von einem Parameter, nämlich vom Abstand zu einer optischen Achse, abhängt, wohingegen die erfindungsgemäßen Freiformflächen mindestens zwei voneinander unabhängige Parameter zur Flächenbeschreibung erfordern. Kegelschnitt-Asphärenflächen sind daher keine erfindungsgemäßen Freiformflächen. Auf die Form einer Berandung der optisch wirksamen Fläche kommt es dabei nicht an. Natürlich sind aus dem Stand der Technik optisch wirksame Flächen bekannt, die nicht rotationssymmetrisch berandet sind. Derartige optisch wirksame Flächen sind trotzdem durch eine rotationssymmetrische Funktion beschreibbar, wobei ein nicht rotationssymmetrisch berandeter Ausschnitt dieser optischen Fläche zum Einsatz kommt. Unter einer statischen Freiformfläche wird eine Freiformfläche verstanden, die während des Projektionseinsatzes der Projektionsoptik nicht aktiv in ihrer Form verändert wird. Natürlich kann auch eine statische Freiformfläche insgesamt zu Justagezwecken verlagert werden. Die Freiformfläche kann insbesondere ausgehend von einer planen Referenzfläche bzw. Grundform, von einer konkaven Referenzfläche oder von einer konvexen Referenzfläche designt werden. Insbesondere kann mindestens eine Freiformfläche eingesetzt werden, die ausgehend von einer gekrümmten Referenzfläche designt wurde. Dabei wird bevorzugt eine Referenzfläche mit einer Scheitelpunktkrümmung herangezogen, die über die gesamte Referenzfläche konstant ist. Auch eine Kegelschnitt-Asphäre kann als Referenzfläche herangezogen werden. Gerade bei den gattungsgemäßen abbildenden Optiken mit Durchgangsöffnung, die auch als pupillenobskurierte Systeme bekannt sind, bietet der Einsatz von derartigen Freiformflächen die Möglichkeit, kompakte Abbildungsoptiken mit geringen Abbildungsfehlern und insbesondere hohem Lichtdurchsatz zu realisieren. Je nach Anzahl der Spiegel der abbildenden Optik kann ein einziger Spiegel oder es können mehrere oder auch alle Spiegel der abbildenden Optik als Freiformflächen ausgeführt sein. Von einer an die Freiformfläche bestangepassten rotationssymmetrischen Fläche, die mit einer Design-Referenzfläche nicht übereinstimmen muss, haben die erfindungsgemäßen Freiformflächen bevorzugt eine maximale Abweichung von mindestens dem Betrag der Wellenlänge des Abbildungslichts. Diese Abweichung von insbesondere mindestens dem Betrag einer Wellenlänge des Abbildungslichts ist in der Praxis immer deutlich größer als Fertigungstoleranzen bei der Herstellung optischer Komponenten für die Mikrolithographie, die absolut bei typisch 0,1 nm und relativ bei typisch 1/50 oder 1/100 der Wellenlänge des eingesetzten Beleuchtungslichts liegen. Bei einer Beleuchtung mit EUV-Wellenlängen beträgt diese Abweichung mindestens einige 10 nm, z. B. 50 nm. Auch größere Abweichungen, z. B. von 100 nm, 500 nm oder 1.000 nm oder sogar noch größere Abweichungen sind möglich. Beim Einsatz von Systemen mit Abbildungslicht höherer Wellenlänge sind sogar noch höhere Abweichungen möglich. Eine erfindungsgemäße Freiformfläche kann gegeben sein durch eine bikonische Oberfläche, d.h. eine optische Fläche mit zwei verschiedenen Basiskrümmungen und zwei verschiedenen konischen Konstanten in zwei aufeinander senkrecht stehenden Richtungen, durch eine torische Oberfläche oder durch eine anamorphe und gleichzeitig insbesondere asphärische Oberfläche. Auch eine zylindrische Oberfläche stellt daher eine derartige Freiformfläche dar. Die erfindungsgemäßen Freiformflächen können zu einer oder zu mehreren Symmetrieebenen spiegelsymmetrisch sein. Die erfindungsgemäße Freiformfläche kann eine Fläche sein, die eine n-zählige Symmetrie aufweist, wobei n ganzzahlig und größer gleich 1 ist. Bei der erfindungsgemäßen Freiformfläche kann auch überhaupt keine Symmetrieachse und überhaupt keine Symmetrieebene vorliegen.

Verschiedene Möglichkeiten zur Beschreibung optischer Oberflächen, insbesondere anamorpher Oberflächen, sind beispielsweise in der US 6,000,798 beschrieben. Analytische Formeln zur Beschreibung nicht rotationssymmetrischer Oberflächen, insbesondere anamorpher asphärischer Oberflächen, torischer Oberflächen oder bikonischer asphärischer Oberflächen, sind zudem in der WO 01/88597 A beschrieben. Soweit die Offenbarung dieser Dokumente sich auf die mathematische Beschreibung optischer Oberflächen bezieht, soll diese Beschreibung die hier vorgenommene Beschreibung ergänzen. Auch einige optische Designprogramme wie Oslo® und Code V® ermöglichen eine Beschreibung und ein Design optischer Systeme über mathematische Funktionen, über die auch eine Vorgabe von nicht rotationssymmetrischen optischen Oberflächen möglich ist. Die vorstehend erwähnten mathematischen Beschreibungen beziehen sich auf mathematische Flächen. Eine tatsächlich optisch genutzte optische Fläche, d.h. eine physikalische Oberfläche eines optischen Elements, die mit einem Beleuchtungsstrahl beaufschlagt ist und die mit einer derartigen mathematischen Beschreibung beschrieben werden kann, beinhaltet im Allgemeinen lediglich einen Ausschnitt der tatsächlichen mathematischen Oberfläche, die auch als Parentfläche bezeichnet ist. Die mathematische Oberfläche erstreckt sich also auch über die physikalische, optisch wirksame Oberfläche hinaus. Soweit ein optisches System mithilfe einer Referenzachse beschrieben werden kann, können einige oder alle optisch verwendeten Flächenabschnitte derart außerhalb dieser Referenzachse angeordnet sein, dass die Referenzachse zwar die mathematische Oberfläche, nicht aber den tatsächlich optisch genutzten Ausschnitt dieser mathematischen Oberfläche schneidet.

Parallel nach Anspruch 2 zueinander angeordnete Feldebenen erleichtern die Integration der abbildenden Optik in eine bauliche Umgebung. Insbesondere dann, wenn die abbildende Optik in einer scannenden Projektionsbelichtungsanlage eingesetzt wird, kommt dieser Vorteil zum Tragen, da dann die Scanrichtungen zueinander parallel geführt werden können.

Ein maximaler Reflexionswinkel nach Anspruch 3 führt zur Möglichkeit, die abbildende Optik hocheffizient als Projektionsoptik für eine EUV-Projektionsbelichtungsanlage einzusetzen, da dann die Spiegel mit über deren gesamte Apertur gleichbleibend hochreflektiven Reflexionsschichten belegbar sind. Dieser Vorteil ist insbesondere für die p-Polarisationskomponenten reflektierter Strahlung wichtig, da die Reflektivität der p-Polarisationskomponente bei höheren Reflexionswinkeln schnell abnimmt.

Eine abbildende Optik nach Anspruch 4 bietet beim Einsatz in einer EUV-Projektionsbelichtungsanlage einen guten Kompromiss zwischen hohem EUV-Durchsatz und optimierter Strukturauflösung.

Ein Spiegel mit einer konvexen Grundform nach Anspruch 5 erlaubt eine gute Petzval-Korrektur der abbildenden Optik.

Spiegelanzahlen nach Anspruch 6 haben sich für das Design einer gleichzeitig kompakten und hinsichtlich ihrer Abbildungsfehler gut korrigierten abbildenden Optik als besonders geeignet herausgestellt.

Spiegel mit Hauptstrahlwinkelvergrößerungen nach den Ansprüchen 7 und 8 ermöglichen Designs mit geringen maximalen Reflexionswinkeln. Auch abbildende Optiken mit drei Spiegeln mit negativer Hauptstrahlwinkelvergrößerung sind möglich. Die Hauptstrahlwinkelvergrößerung ist definiert als der Winkel eines Hauptstrahls, der zu einem zentralen Feldpunkt gehört, und einer Referenzachse. Die Referenzachse steht senkrecht auf der Objektebene der Projektionsbelichtungsanlage und verläuft durch den Mittelpunkt des Objektfeldes.

Ein Strahlwinkel nach Anspruch 9 erzeugt bei einer Defokussierung nur einen geringen lateralen Bildversatz in der Bildebene.

Ein Zwischenbild mit einem Abbildungsmaßstab nach Anspruch 10 erlaubt den Einsatz eines relativ großen vorletzten Spiegels im Strahlengang vor dem Bildfeld. Dies reduziert einerseits die maximalen Reflexionswinkel und verringert andererseits, falls der vorletzte Spiegel obskuriert ist, die Größe der Pupillenobskuration. Auch höhere Abbildungsmaßstäbe der Teil-Optik als 2x sind möglich, zum Beispiel mehr als 2,5x oder mehr als 3,0x, insbesondere 3,2x.

Eine Anordnung nach Anspruch 11 erlaubt den Einsatz eines vorletzten Spiegels mit relativ kleiner Durchgangsöffnung. Dies sorgt einerseits für einen stabilen vorletzten Spiegel und andererseits für eine geringe Pupillenobskuration.

Ein schwach gekrümmter vorletzter Spiegel nach Anspruch 12 ermöglicht bei einer gegebenen bildseitigen numerischen Apertur eine kleine Durchgangsöffnung relativ zum Spiegeldurchmesser in diesem vorletzten Spiegel.

Ein Bildfeld nach Anspruch 13 führt beim Einsatz der abbildenden Optik in einer Projektionsbelichtungsanlage zu einem guten Durchsatz.

Eine bildseitige numerische Apertur nach Anspruch 14 erlaubt eine hohe Auflösung der abbildenden Optik.

Eine bildseitig telezentrische abbildende Optik nach Anspruch 15 erlaubt beispielsweise eine Nachfokussierung des Systems in der Bildebene, ohne dass sich hierdurch der Abbildungsmaßstab verändert, und erhöht damit die Anwendungsflexibilität der abbildenden Optik. Objektseitig kann die abbildende Optik so ausgebildet sein, dass Einzelstrahlen, die verschiedenen Objektfeldpunkten, aber den gleichen Beleuchtungsrichtungen zugeordnet sind, konvergent aus dem Objektfeld in die abbildende Optik hineinlaufen. Alternativ ist es auch möglich, derartige Einzelstrahlen divergent oder auch parallel in die abbildende Optik einlaufen zu lassen. Im letzten Fall resultiert eine objektseitig telezentrische abbildende Optik.

Ein geringer Objekt-Bild-Versatz nach Anspruch 16 führt zu einer kompakten abbildenden Optik und erleichtert zudem Optik-Testverfahren, bei dem die abbildende Optik um eine zentral durch das Objekt- oder Bildfeld verlaufende und senkrecht auf der entsprechenden Feldebene stehende Achse verschwenkt wird, da dann Objekt- bzw. Bildfeld beim Schwenken nicht zu stark wandern.

Mindestens ein Spiegelpaar, welches die Abstandsbedingung nach Anspruch 17 erfüllt, erleichtert die Einhaltung kleiner Einfallswinkel im Strahlengang des Abbildungslichts durch die abbildende Optik. Kleine Einfallswinkel führen wiederum zur Möglichkeit hoch reflektierender Spiegel auch im Bereich von EUV-Wellenlängen. Insbesondere 2, 3, 4 oder auch mehr Spiegelpaare können diese Abstandsbedingung erfüllen.

Mindestens ein Spiegel mit einem minimalen Abstand nach Anspruch 18 führt zu einer abbildenden Optik, bei der die Einfallswinkel auf den Spiegeln so klein wie möglich gehalten sind. Die Vorteile kleiner Einfallswinkel auf den Spiegeln wurden vorstehend schon diskutiert. Diesen minimalen Abstand können insbesondere 2, 3 oder 4 Spiegel der abbildenden Optik aufweisen. Bevorzugt ist, dass dieser minimale Abstand kleiner ist als 25 mm, jedoch größer als 5 mm, damit die baulichen Anforderungen an die Spiegel nicht zu hoch sind.

Eine abbildende Optik nach Anspruch 19, bei der der letzte Spiegel im Abbildungsstrahlengang die Durchgangsöffnung aufweist, ermöglicht eine hohe numerische Apertur bei kompaktem und abbildungsfehlerminimiertem Aufbau.

Die Vorteile einer Projektionsbelichtungsanlage nach Anspruch 20 und 21 entsprechen denjenigen, die vorstehend in Bezug auf die erfindungsgemäße abbildende Optik ausgeführt wurden. Die Lichtquelle der Projektionsbelichtungsanlage kann breitbandig ausgeführt sein und beispielsweise eine Bandbreite haben, die größer ist als 1 nm, die größer ist als 10 nm oder die größer ist als 100 nm. Zudem kann die Projektionsbelichtungsanlage so ausgeführt sein, dass sie mit Lichtquellen unterschiedlicher Wellenlängen betrieben werden kann.

Entsprechende Vorteile gelten für das Herstellungsverfahren nach Anspruch 22 und das hierdurch hergestellte mikrostrukturierte Bauteil nach Anspruch 23.

Bei der Verwendung der abbildenden Optik als Mikroobjektiv nach Anspruch 24 und 25 ergibt sich der Vorteil, dass im Bereich des Zwischenbildes kein sehr kleiner Spiegel durchgebohrt werden muss, wie dies bei der US 6 894 834 B2 der Fall ist.

Ausführungsbeispiele der Erfindung werden nachfolgend anhand der Zeichnung näher erläutert. In dieser zeigen:

Fig. 1          schematisch eine Projektionsbelichtungsanlage für die Mikrolithografie;

Fig. 2          einen Abbildungsstrahlungsgänge zueinander beabstandeter Feldpunkte beinhaltenden Schnitt durch eine Ausführung einer Projektionsoptik der Projektionsbelichtungsanlage nach Fig. 1;

Fig. 3          eine Aufsicht auf ein Bildfeld der Projektionsoptik nach Fig. 2 aus Blickrichtung III in Fig. 2;

Fig. 4          einen Schnitt durch eine nicht-rotationssymmetrische Freiformfläche und durch eine rotationssymmetrische Fläche;

Fig. 5          einen Schnitt durch einen Abschnitt eines Spiegels der Projektionsoptik nach Fig. 2;

Fig. 6          schematisch einen Strahlengang an einem Spiegel der Projektionsoptik nach Fig. 2 mit positiver Hauptstrahlwinkelvergrößerung;

Fig. 7          schematisch einen Strahlengang an einem Spiegel der Projektionsoptik nach Fig. 2 mit negativer Hauptstrahlwinkelvergrößerung;

Fig. 8          eine zu Fig. 1 ähnliche Darstellung einer Projektionsbelichtungsanlage für die Mikrolithografie;

Fig. 9          eine Ausschnittsvergrößerung eines mit der Projektionsbelichtungsanlage nach den Fig. 1 oder 8 belichteten Wafers und eines diesem nächst benachbarten Spiegels;

Fig. 10         eine zu Fig. 2 ähnliche Darstellung einer weiteren Ausführung einer Projektionsoptik;

Fig. 11         eine zu Fig. 2 ähnliche Darstellung einer weiteren Ausführung einer Projektionsoptik;

Fig. 12         eine zu Fig. 2 ähnliche Darstellung einer weiteren Ausführung einer Projektionsoptik;

Fig. 13          eine zu Fig. 11 ähnliche Darstellung eines Mikroskopobjektivs zur Waferinspektion;

Fig. 14 u. 15          zwei weitere zu Fig. 2 ähnliche Darstellungen weiterer Ausführungen einer Projektionsoptik;

Fig. 16 u. 17          zu Fig. 13 ähnliche Darstellungen weiterer Ausruhrungen eines Mikroskopobjektivs zur Waferinspektion.

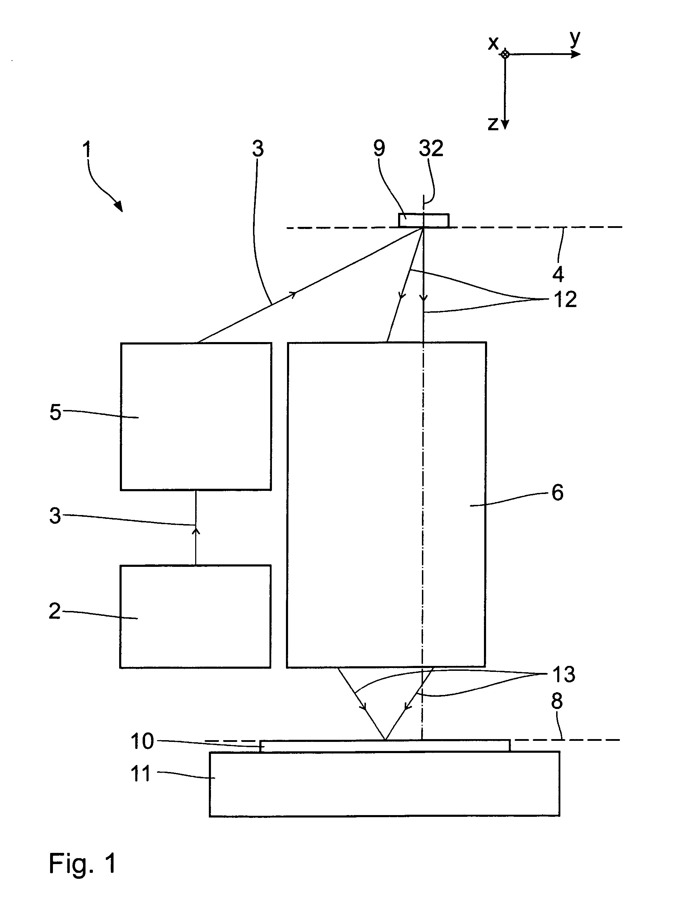

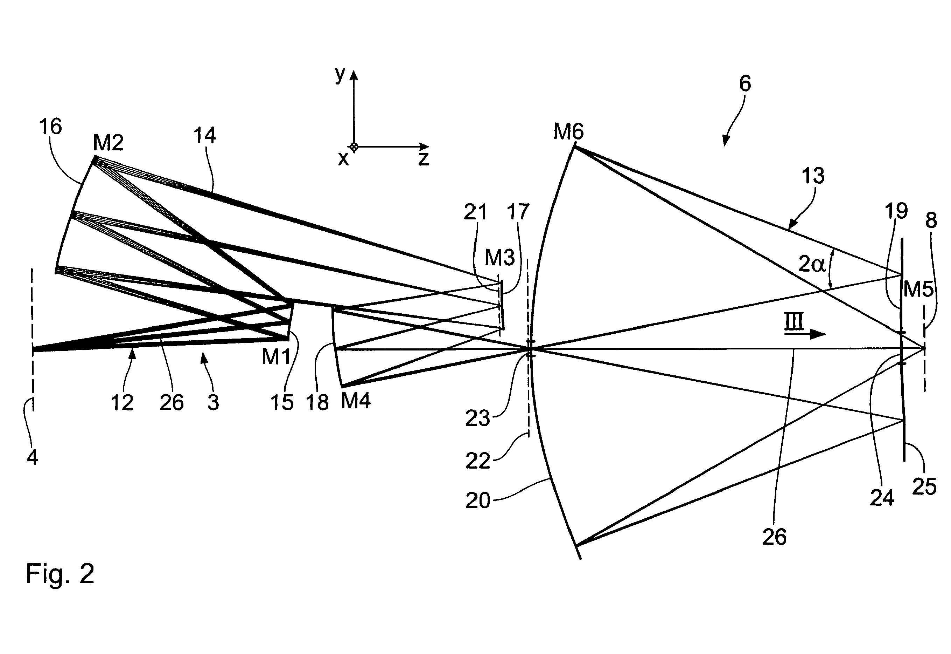

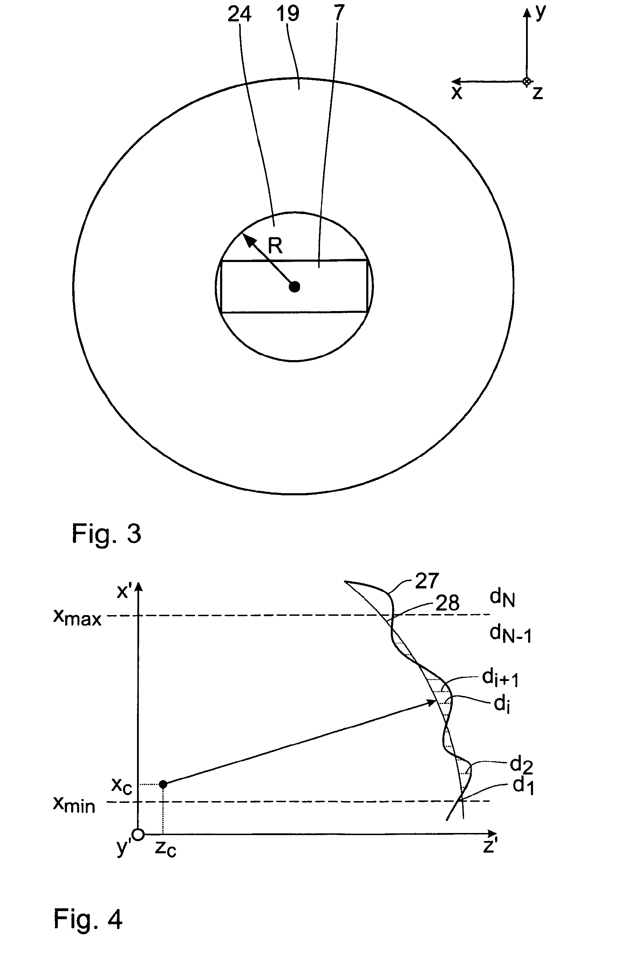

Eine Projektionsbelichtungsanlage 1 für die Mikrolithografie hat eine Lichtquelle 2 für Beleuchtungslicht. Bei der Lichtquelle 2 handelt es sich um eine EUV-Lichtquelle, die Licht in einem Wellenlängenbereich zwischen 10 nm und 30 nm erzeugt. Auch andere EUV-Wellenlängen sind möglich. Generell sind sogar beliebige Wellenlängen, z. B. sichtbare Wellenlängen, für das in der Projektionsbelichtungsanlage 1 geführte Beleuchtungslicht möglich. Ein Strahlengang des Beleuchtungslichts 3 ist in der Fig. 1 äußerst schematisch dargestellt.
Zur Führung des Beleuchtungslichts 3 hin zu einem Objektfeld in einer Objektebene 4 dient eine Beleuchtungsoptik 5. Mit einer Projektionsoptik 6 wird das Objektfeld in ein Bildfeld 7 (vgl. Fig. 3) in einer Bildebene 8 mit einem vorgegebenen Verkleinerungsmaßstab abgebildet. Die Projektionsoptik 6 verkleinert um einen Faktor 8. Andere Abbildungsmaßstäbe sind ebenfalls möglich, zum Beispiel 4x, 5x, 6x oder auch Abbildungsmaßstäbe, die größer sind als 8x. Für Beleuchtungslicht mit EUV-Wellenlänge eignet sich insbesondere ein Abbildungsmaßstab von 8x, da hierdurch der objektseitige Einfallswinkel auf einer Reflexionsmaske klein gehalten werden kann. Für eine bildseitige Apertur der Projektionsoptik von NA = 0,5 lassen sich objektseitig Beleuchtungswinkel von weniger als 6° realisieren. Ein Abbildungsmaßstab von 8x führt zudem nicht zur Notwendigkeit, unnötig große Masken einzusetzen. Die Bildebene 8 ist bei der Projektionsoptik 6 nach Fig. 2 parallel zur Objektebene 4 angeordnet. Abgebildet wird hierbei ein mit dem Objektfeld zusammenfallender Ausschnitt einer reflektierenden Maske 9, die auch als Retikel bezeichnet wird. Die Abbildung erfolgt auf die Oberfläche eines Substrats 10 in Form eines Wafers, der von einem Substrathalter 11 getragen wird. In der Fig. 1 ist schematisch zwischen dem Retikel 9 und der Projektionsoptik 6 ein in diese einlaufendes Strahlenbündel 12 des Beleuchtungslichts 3 und zwischen der Projektionsoptik 6 und dem Substrat 10 ein aus der Projektionsoptik 6 auslaufendes Strahlungsbündel 13 des Beleuchtungslichts 3 dargestellt. Die bildfeldseitige numerische Apertur der Projektionsoptik 6 nach Fig. 2 beträgt 0,50. Die Projektionsoptik 6 ist bildseitig telezentrisch.
Zur Erleichterung der Beschreibung der Projektionsbelichtungsanlage 1 ist in der Zeichnung ein kartesisches xyz-Koordinatensystem angegeben, aus dem sich die jeweilige Lagebeziehung der in den Figuren dargestellten Komponenten ergibt. In der Fig. 1 verläuft die x-Richtung senkrecht zur Zeichenebene in diese hinein, die y-Richtung nach rechts und die z-Richtung nach unten.
Die Projektionsbelichtungsanlage 1 ist vom Scannertyp. Sowohl das Retikel 9 als auch das Substrat 10 werden beim Betrieb der Projektionsbelichtungsanlage 1 in der y-Richtung gescannt.
Fig. 2 zeigt das optische Design der Projektionsoptik 6. Dargestellt ist der Strahlengang jeweils dreier Einzelstrahlen 14, die von fünf in der Fig. 2 übereinanderliegenden und zueinander in der γ-Richtung beabstandeten Objektfeldpunkten ausgehen, wobei die drei Einzelstrahlen 14, die zu einem dieser fünf Objektfeldpunkte gehören, jeweils drei unterschiedlichen Beleuchtungsrichtungen für die fünf Objektfeldpunkte zugeordnet sind.
Ausgehend von der Objektebene 4 werden die Einzelstrahlen 14 zunächst von einem ersten Spiegel 15, der nachfolgend auch als Spiegel M1 bezeichnet wird, und anschließend von weiteren Spiegeln 16, 17, 18, 19, 20 reflektiert, die nachfolgend auch, in der Reihenfolge des Strahlengangs, als Spiegel M2, M3, M4, M5 und M6 bezeichnet werden. Die Projektionsoptik 6 nach Fig. 2 hat also sechs reflektierende Spiegel. Diese Spiegel tragen eine für die Wellenlänge des Beleuchtungslicht hoch reflektierende Beschichtung, falls dies aufgrund der Wellenlänge, zum Beispiel im EUV, erforderlich ist. In der Beleuchtungsoptik 5 und der Projektionsoptik 6 lassen sich auch Strahlungen mit voneinander stark unterschiedlicher Wellenlänge führen, da diese Optiken im Wesentlichen achromatische Eigenschaften haben. Es ist also möglich, in diesen Optiken zum Beispiel einen Justagelaser zu führen oder ein Autofokussiersystem zu betreiben, wobei gleichzeitig mit einer von deren Arbeitswellenlänge stark verschiedenen Wellenlänge für das Beleuchtungslicht gearbeitet wird. So kann ein Justagelaser bei 632,8 nm, bei 248 nm oder bei 193 nm arbeiten, während gleichzeitig mit einem Beleuchtungslicht im Bereich zwischen 10 und 30 nm gearbeitet wird.
Die Spiegel 15, 17 und 19 haben eine konvexe Grundform, können also durch eine konvexe bestangepasste Fläche beschrieben werden. Insbesondere hat der dritte Spiegel 17 eine konvexe Grundform. Die Spiegel 16, 18 und 20 haben eine konkave Grundform, können also durch eine konkave bestangepasste Fläche beschrieben werden. In der nachfolgenden Beschreibung werden derartige Spiegel vereinfacht nur als konvex oder konkav bezeichnet. Der konvexe Spiegel 17 sorgt für eine gute Petzval-Korrektur bei der Projektionsoptik 6.
Diejenigen Einzelstrahlen 14, die von beabstandeten Objektfeldpunkten ausgehen und der gleichen Beleuchtungsrichtung zugeordnet sind, laufen zwischen der Objektebene 4 und dem ersten Spiegel M1 konvergent in die Projektionsoptik 6 hinein. Das Design der Projektionsoptik 6 kann so angepasst werden, dass die gleichen Beleuchtungsrichtungen für die Objektfeldpunkte zugeordneten Einzelstrahlen 14 zwischen diesen Komponenten auch divergent oder parallel zueinander verlaufen. Die letzte Variante entspricht einem objektseitig telezentrischen Strahlengang.
Die zu einer bestimmten Beleuchtungsrichtung der fünf Objektfeldpunkte 3 gehörenden Einzelstrahlen 14 vereinigen sich in einer Pupillenebene 21 der Projektionsoptik 6, zu der der Spiegel 17 benachbart angeordnet ist. Dieser Spiegel 17 wird daher auch als Pupillenspiegel bezeichnet. In der Pupillenebene 21 kann eine Aperturblende zur Begrenzung des Beleuchtungslicht-Strahlbündels angeordnet sein. Diese Aperturblende kann durch eine mechanische und auswechselbare Blende oder aber in Form einer entsprechenden Beschichtung direkt auf dem Spiegel M3 vorgesehen sein.

Die Spiegel 15 bis 18 bilden die Objektebene 4 ab in eine Zwischenbildebene 22. Die zwischenbildseitige numerische Apertur der Projektionsoptik 6 beträgt 0,2. Die Spiegel 15 bis 18 bilden eine erste Teil-Abbildungsoptik der Projektionsoptik 6 mit einem verkleinernden Abbildungsmaßstab von 3,2x. Die nachfolgenden Spiegel 19 und 20 bilden eine weitere Teil-Abbildungsoptik der Projektionsoptik 6 mit einem verkleinernden Abbildungsmaßstab von 2,5x. Im Bereich der Zwischenbildebene 22 ist eine Durchgangsöffnung 23 im sechsten Spiegel 20 ausgebildet, durch die das Beleuchtungs- bzw. Abbildungslicht 3 bei der Reflexion vom vierten Spiegel 18 hin zum fünften Spiegel 19 hindurchtritt. Der fünfte Spiegel 19 wiederum hat eine zentrale Durchgangsöffnung 24, durch die das Strahlungsbündel 13 zwischen dem sechsten Spiegel 20 und der Bildebene 8 hindurchtritt.

Der fünfte Spiegel 19, der zusammen mit dem sechsten Spiegel 20 das Beleuchtungs- bzw. Abbildungslicht 3 von der Zwischenbildebene 22 in die Bildebene 8 abbildet, ist in der Nähe einer zur ersten Pupillenebene 21 konjugierten weiteren Pupillenebene 25 der Projektionsoptik 6 angeordnet. Typischerweise befindet sich die weitere Pupillenebene 25 im Strahlengang des Abbildungslichts 3 zwischen dem fünften Spiegel 19 und dem sechsten Spiegel 20, sodass am Ort der weiteren Pupillenebene 25 eine physikalisch zugängliche Blendenebene existiert. In dieser Blendenebene kann alternativ oder zusätzlich ebenfalls eine Aperturblende angeordnet sein, wie vorstehend im Zusammenhang mit der Aperturblende im Bereich der Pupillenebene 21 beschrieben.

Die Projektionsoptik 6 hat in einer der Pupillenebenen 21, 25 eine zentriert angeordnete Obskurationsblende. Hierdurch werden die den zentralen Durchgangsöffnungen 23, 24 in den Spiegeln 20, 19 zugeordneten Teilstrahlen des Projektionsstrahlengangs obskuriert. Daher wird das Design der Projektionsoptik 6 auch als Design mit zentraler Pupillenobskuration bezeichnet.

Ein ausgezeichneter Einzelstrahl 14, der einen zentralen Objektfeldpunkt mit einem zentral ausgeleuchteten Punkt in der Eintrittspupille der Projektionsoptik 6 in der Eintritts-Pupillenebene 21 verbindet, wird nachfolgend auch als Hauptstrahl 26 eines zentralen Feldpunktes bezeichnet. Der Hauptstrahl 26 des zentralen Feldpunktes schließt ab der Reflexion am sechsten Spiegel 20 mit der Bildebene 8 näherungsweise einen rechten Winkel ein, verläuft also in etwa parallel zur z-Achse der Projektionsbelichtungsanlage 1. Dieser Winkel ist in jedem Fall größer als 85 °.

Das Bildfeld 7 ist rechteckig. Das Aspektverhältnis des Bildfelds 7 ist in der Fig. 3 nicht maßstabsgetreu wiedergegeben. Parallel zur x-Richtung hat das Bildfeld 7 eine Ausdehnung von 13 mm. Parallel zur y-Richtung hat das Bildfeld 7 eine Ausdehnung von 1 mm. Das Bildfeld 7 liegt, wie in der Fig. 3 dargestellt, zentrisch hinter dem fünften Spiegel 19. Ein Radius R der Durchgangsöffnung 24 ergibt sich aus:

$$R = \frac{1}{2} \cdot D + d_w \cdot NA.$$

D ist dabei die Diagonale des Bildfelds 7. $d_w$ ist der Arbeitsabstand des Spiegels 19 von der Bildebene. NA ist die bildseitige numerische Apertur.

Alle sechs Spiegel 15 bis 20 der Projektionsoptik 6 sind als nicht durch eine rotationssymmetrische Funktion beschreibbare Freiformflächen ausgeführt. Es sind auch andere Ausführungen der Projektionsoptik 6 möglich, bei denen mindestens einer der Spiegel 15 bis 20 eine derartige Freiform-Reflexionsfläche aufweist.

Die Erzeugung einer derartigen Freiformfläche 27 aus einer rotationssymmetrischen Referenzfläche 28 wird nachfolgend anhand der Fig. 4 beschrieben. Zunächst werden mit Hilfe eines optischen Designprogrammes Informationen zur Charakterisierung der betrachteten Freiformfläche gewonnen. Die Referenzfläche 28 kann z. B. eine rotationssymmetrische Asphäre sein. Zu den Design-Informationen können der Krümmungsradius der Referenzfläche 28 gehören, der auch als 1/c bezeichnet wird, wobei c die Scheitelkrümmung der Referenzfläche 28 bezeichnet. Zu den Informationen gehören zudem eine konische Konstante k der Referenzfläche 28 und Polynomkoeffizienten, die die Referenzfläche 28 beschreiben.

Alternativ oder zusätzlich können die Referenzfläche 28 charakterisierende Informationen aus einer Oberflächenmessung einer Referenz-Spiegeloberfläche, z. B. unter Nutzung eines Interferometers, gewonnen werden. Eine derartige Oberflächenmessung ergibt eine Funktion z'(x', y'), die die Referenzfläche 28 beschreibt, wobei z' die Pfeilhöhe der Referenzfläche 28 längs der z'-Achse für verschiedene (x', y') Koordinaten bezeichnet, wie in der Fig. 4 dargestellt.

Dieser erste Schritt beim Design der Freiformfläche beinhaltet zudem die Bestimmung desjenigen Abschnitts der nur durch die Flächenbeschreibung definierten, zunächst unbegrenzten Spiegeloberfläche, der tatsächlich zur Reflexion von Beleuchtungs- oder Abbildungslicht 3 bei der Abbildung des Objektfeldes in das Bildfeld 7 genutzt wird. Dieser Bereich wird auch als Footprint bezeichnet. Der Footprint des Spiegels kann durch Ray Tracing der Projektionsoptik 6 zumindest in einer Näherung bestimmt werden. Beispiele für einen möglichen Footprint in der x-Dimension sind in der Fig. 4 angegeben. xmin bezeichnet die Untergrenze und xmax die Obergrenze für den beispielhaften Footprint. Die Daten oberhalb von xmax und unterhalb von xmin werden innerhalb gewisser Grenzen ebenfalls berechnet, damit bei der Bestimmung der Freiformfläche 27 keine unerwünschten Randeffekte auftreten.

Nachdem die die Referenzfläche 28 charakterisierende Information bestimmt wurde, wird ein lokales Koordinatensystem für die Referenzfläche 28 eingeführt, bei dem sowohl die Dezentrierung als auch die Verkippung der Referenzfläche 28 jeweils Null sind. Die z'-Achse ist also die Rotations-Symmetrieachse der asphärischen Referenzfläche 28 oder aber, soweit die Referenzfläche durch eine Oberflächenmessung gewonnen wurde, die optische Achse des Messgeräts, z. B. des Interferometers. Die z'-Achse ist in der Regel relativ zur z-Achse des xyz-Koordinatensystems der Projektionsbelichtungsanlage 1 parallel verschoben und verkippt. Dies gilt entsprechend für die anderen Koordinatenachsen x', y'. Diese Parallelverschiebung bzw. Verkippung wird im Ausgangsschritt des optischen Designs der Freiformfläche festgelegt.

Alternativ zu einer Asphäre kann die Referenzfläche 28 auch eine sphärische Fläche sein. Der Koordinatenursprung $x_c$, $y_c$, $z_c$ zur Beschreibung der sphärischen Referenzfläche 28 unterscheidet sich in der Regel vom Ursprung der xyz-Koordinatensystems der Projektionsbelichtungsanlage 1.

Nach der Bestimmung der Referenzfläche 28 wird ein lokaler Abstand $d_i$ (i = 1... N) zwischen einer Anzahl von Punkten auf der Referenzfläche 28 und Punkten auf der Freiformfläche 27 parallel zur z'-Achse bestimmt. Die verschiedenen lokalen Abstände $d_i$ werden nun solange variiert, bis eine Gruppe von Nebenbedingungen erfüllt ist. Diese Nebenbedingungen sind vorgegebene Grenzwerte für bestimmte Abbildungsfehler und/oder Beleuchtungseigenschaften der Projektionsoptik 6.

Die Freiformfläche kann mathematisch durch folgende Gleichung beschrieben werden:

$$Z = \frac{cr^2}{1 + \sqrt{1 - (1+k)c^2 r^2}} + \sum_{j=2}^{66} C_j X^m Y^n$$

wobei gilt:

$$j = \frac{(m+n)^2 + m + 3n}{2} + 1$$

Z ist die Pfeilhöhe der Freiformfläche parallel zu einer Z-Achse, die beispielsweise parallel zur z'-Achse nach Fig. 4 sein kann.

c ist eine Konstante, die der Scheitelpunktkrümmung einer entsprechenden Asphäre entspricht. k entspricht einer konischen Konstante einer entsprechenden Asphäre. $C_j$ sind die Koeffizienten der Monome $X^m Y^n$. Typischerweise werden die Werte von c, k und $C_j$ auf der Basis der gewünschten optischen Eigenschaften des Spiegels innerhalb der Projektionsoptik 6 bestimmt. Die Ordnung des Monoms, m + n, kann beliebig variiert werden. Ein Monom höherer Ordnung kann zu einem Design der Projektionsoptik mit besserer Bildfehlerkorrektur führen, ist jedoch aufwendiger zu berechnen. m + n kann Werte zwischen 3 und mehr als 20 einnehmen.

Freiformflächen können mathematisch auch durch Zernike-Polynome beschrieben werden, die beispielsweise im Manual des optischen Designprogramms CODE V® erläutert werden. Alternativ können Freiformflächen mit Hilfe zweidimensionaler Spline-Oberflächen beschrieben werden. Beispiele hierfür sind Bezier-Kurven oder nicht-uniforme rationale Basis-Splines (non-uniform rational basis splines, NURBS). Zweidimensionale Spline-Oberflächen können beispielsweise durch ein Netz von Punkten in einer xy-Ebene und zugehörige z-Werte oder durch diese Punkte und ihnen zugehörige Steigungen beschrieben werden. Abhängig vom jeweiligen Typ der Spline-Oberfläche wird die vollständige Oberfläche durch Interpolation zwischen den Netzpunkten unter Verwendung z. B. von Polynomen oder Funktionen, die bestimmte Eigenschaften hinsichtlich ihrer Kontinuität und Differenzierbarkeit haben, gewonnen. Beispiele hierfür sind analytische Funktionen.

Die Spiegel 15 bis 20 tragen Mehrfach-Reflexionsschichten zur Optimierung ihrer Reflexion für das auftreffende EUV-Beleuchtungslicht 3. Die Reflexion ist umso besser, je näher der Auftreffwinkel der Einzelstrahlen 14 auf der Spiegeloberfläche an der senkrechten Inzidenz liegt. Die Projektionsoptik 6 hat insgesamt für alle Einzelstrahlen 14 sehr kleine Reflexionswinkel. Als Reflexionswinkel an einem Punkt auf der Oberfläche deines der Spiegel 15 bis 20 wird nachfolgend der halbe Winkel zwischen dem auf diesen Punkt auftreffenden Einzelstrahl 14 und dem von diesem Punkt reflektierenden Einzelstrahl 14 bezeichnet.

Der maximale Reflexionswinkel liegt bei der Projektionsoptik 6 bei den äußeren Rand-Einzelstrahlen 14 auf dem fünften Spiegel 19 vor. Dieser Winkel α beträgt bei der Projektionsoptik 6 etwa 16 °. Der Quotient aus dem maximalen Reflexionswinkel α und der numerischen Aperatur ist bei der Projektionsoptik 6 nach Fig. 2 also 32 °.

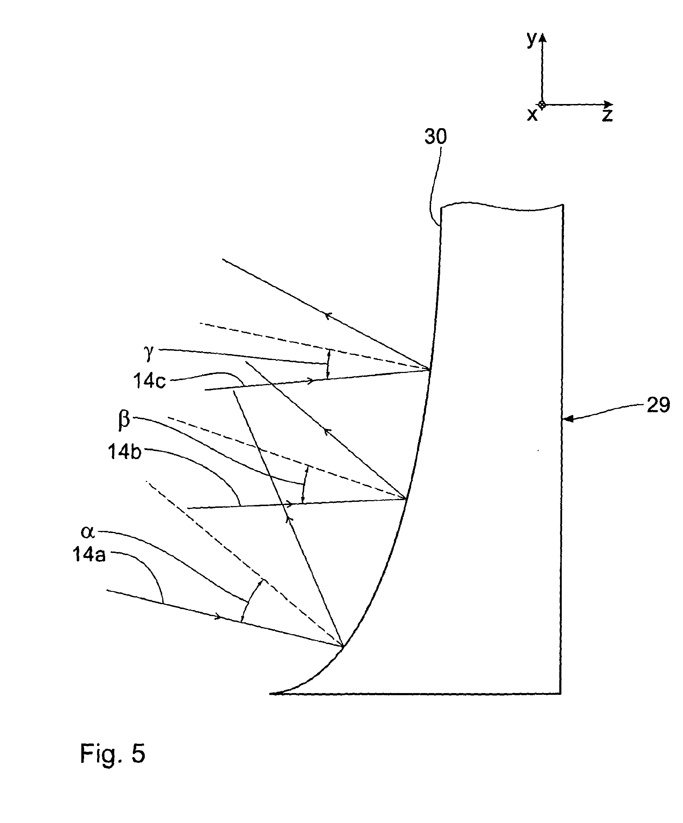

Die Abhängigkeit der Größe der Reflexionswinkel von der Position des Auftreffpunktes auf dem Reflexionsspiegel wird nachfolgend schematisch am Beispiel eines Muster-Reflexionsspiegels 29 erläutert, der in der Fig. 5 dargestellt ist. Dort trifft ein divergentes Bündel aus Einzelstrahlen 14a, 14b, 14c auf eine Reflexionsfläche 30 des Muster-Reflexionsspiegels 29.

Die Reflexionsfläche 30 ist konvex. Aufgrund der sammelnden Wirkung der Reflexionsfläche 30 wird das einfallende tiefergehende Bündel aus den Einzelstrahlen 14a, 14b und 14c in ein reflektiertes konvergentes Bündel umgelenkt. Dabei wird der randseitig auf die Reflexionsfläche 30 auftreffende Einzelstrahl 14a mit dem größten Reflexionswinkel α, der mittlere Einzelstrahl 14b mit einem im Vergleich hierzu kleineren Reflexionswinkel β und der am weitesten vom Rand des Muster-Reflexionsspiegels 29 entfernte Einzelstrahl 14c um den kleinsten Reflexionswinkel γ umgelenkt.

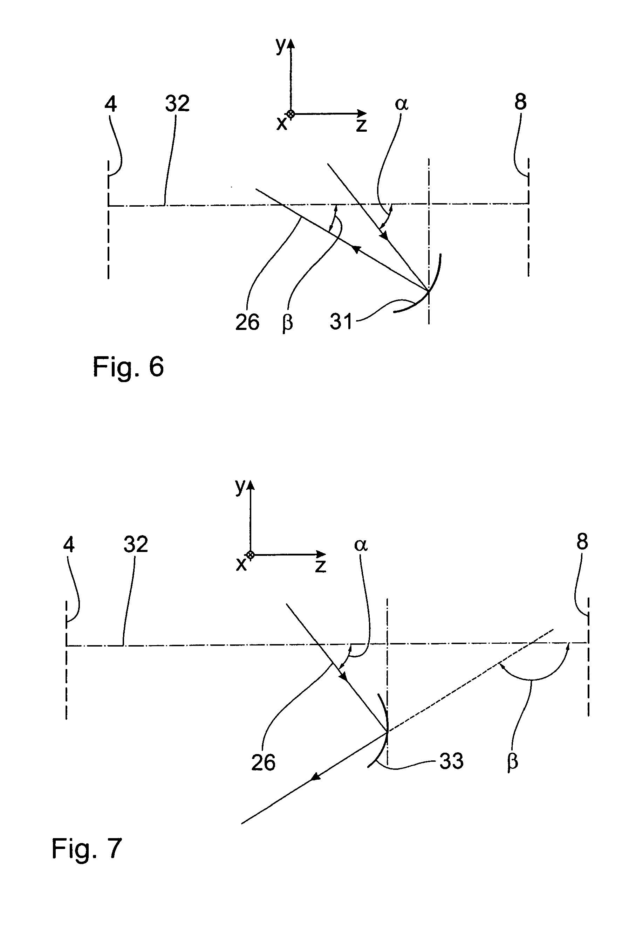

Der Strahlenverlauf innerhalb der Projektionsoptik 6 kann zusätzlich noch durch die Abfolge der Hauptstrahlwinkelvergrößerungen charakterisiert werden. Dies wird nachfolgend anhand der schematischen Fig. 6 und 7 erläutert. In der Fig. 6 wird der Hauptstrahl 26 auf einen Muster-Reflexionsspiegel 31 unter einem Winkel α zu einer Referenzachse 32 eingestrahlt, die senkrecht zur Objektebene 4 der Projektionsbelichtungsanlage 1 verläuft. Objektfeldseitig, also bis einschließlich des Spiegels M4, ist die Referenzachse 32 zusätzlich definiert durch den Mittelpunkt des Objektfeldes. Die Referenzachse 32 fällt in der Regel nicht mit der z-Achse zusammen, verläuft aber parallel zu dieser. Nach Reflexion am Muster-Reflexionsspiegel 31 wird der Hauptstrahl 26 unter einem Winkel β zur Referenzachse 32 zurückreflektiert. Da beide Winkel α, β zwischen 0 und 90 ° liegen, ist der Quotient tanα/tanβ positiv. Der Muster-Reflexionsspiegel 31 hat daher eine positive Hauptstrahlwinkelvergrößerung.

Fig. 7 zeigt den Fall der negativen Hauptstrahlwinkelvergrößerung. Der einfallende Hauptstrahl 26 schneidet die Referenzachse 32 unter einem Winkel α, der zwischen 0 und 90° liegt. Der von einem Muster-Reflexionsspiegel 33 reflektierte Hauptstrahl 26 schließt virtuell mit der Referenzachse 32 einen Winkel β ein, der zwischen 90 und 180 ° liegt. In diesem Fall ist der Quotient tanα/tanβ also negativ.

Bei der Projektionsoptik 6 hat der erste Spiegel 15 eine negative Hauptstrahlwinkelvergrößerung. Der zweite Spiegel 16 hat eine positive Hauptstrahlwinkelvergrößerung. Der dritte Spiegel 17 hat eine negative Hauptstrahlwinkelvergrößerung. Die Hauptstrahlwinkelvergrößerung des vierten Spiegels 18 ist, da dort der Winkel β 180 ° beträgt, unendlich.

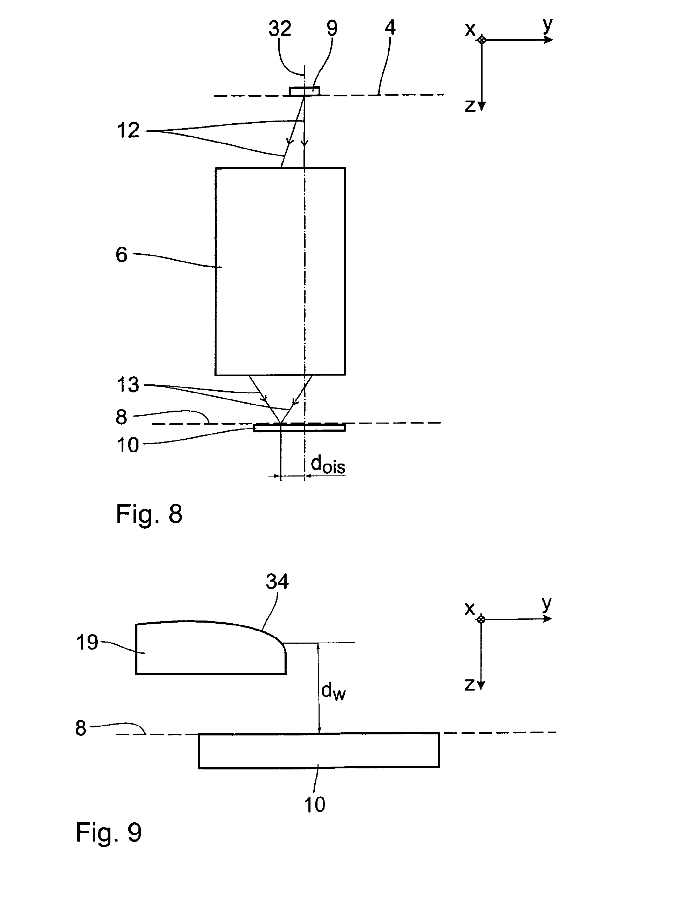

Fig. 8 zeigt nochmals eine leicht abgewandelte Darstellung der Projektionsbelichtungsanlage 1 zur Verdeutlichung eines weiteren, für die Projektionsoptik 6 charakteristischen Wertes, nämlich des Objekt-Bild-Versatzes $d_{ois}$. Dieser ist definiert als der Abstand zwischen einer senkrechten Projektion des zentralen Objektpunktes auf die Bildebene 8 und dem zentralen Bildpunkt. Bei der Projektionsoptik 6 nach Fig. 2 ist der Objekt-Bild-Versatz $d_{ois}$ geringer als 1 mm.

Fig. 9 dient zur Veranschaulichung eines weiteren Charakteristikums der Projektionsoptik 6, nämlich des freien Arbeitsabstandes $d_w$. Dieser ist definiert als der Abstand zwischen der Bildebene 8 und dem dieser nächstliegenden Abschnitt 34 eines der Spiegel der Projektionsoptik 6, also bei der Ausführung nach Fig. 2 dem Spiegel 19.

Bei der Projektionsoptik 6 beträgt der freie Arbeitsabstand $d_w$ 40 mm. Der fünfte Spiegel 19, der der Bildebene 8 am nächsten liegt, kann also mit einer Stärke ausgeführt werden, die für eine ausreichende Stabilität des fünften Spiegels 19 sorgt. Als Materialien für solche Spiegel kommen beispielsweise Quarz, Zerodur oder Siliciumcarbidverbindungen in Frage. Auch andere Materialien mit Ultra Low Expansion-Eigenschaften sind einsetzbar. Beispiele derartiger Materialien sind aus Produkten bekannt, die vom Unternehmen Corning, USA, unter der Bezeichnung "ULE" vertrieben werden.

Optische Daten der Projektionsoptik 6 werden nachfolgend nochmals zusammengefasst:

Die bildseitige numerische Apertur NA beträgt 0,5. Die Größe des Bildfeldes beträgt 1 x 13 mm². Der verkleinernde Abbildungsmaßstab beträgt 8x. Das Bildfeld 7 ist rechteckig. Die Wellenlänge des Beleuchtungslichts beträgt 13,5 nm. Die Abfolge der optischen Wirkungen der Spiegel M1 bis M6 (negativ N; positiv P) ist NPNPNP. Hauptstrahlen laufen von der Objektebene konvergent in die Projektionsoptik ein. Eine Aperturblende zur randseitigen Beleuchtungslicht-Begrenzung ist beim Spiegel M3 angeordnet. Der z-Abstand zwischen der Objektebene 4 und der Bildebene 8 beträgt 1.500 mm. Der Objekt-Bild-Versatz beträgt 0,42 mm. 5,9 % der in den Pupillenebenen ausgeleuchteten Flächen sind obskuriert. Die Projektionsoptik hat einen Wellenfrontfehler (rms) in Einheiten der Wellenlänge des Beleuchtungslichts 3 von 0,02. Die Verzeichnung beträgt 12 nm. Die Bildfeldwölbung beträgt 9 nm. Der Hauptstrahlwinkel am zentralen Objektfeldpunkt beträgt 5,9°. Der Spiegel M1 hat eine Größe (x/y) von 117 x 61 mm². Der Spiegel M2 hat eine Größe von 306 x 143 mm². Der Spiegel M3 hat eine Größe von 80 x 77 mm². Der Spiegel M4 hat eine Größe von 174 x 126 mm². Der Spiegel M5 hat eine Größe von 253 x 245 mm². Der Spiegel M6 hat eine Größe von 676 x 666 mm². Die Abfolge der Hauptstrahl-Einfallswinkel des Hauptstrahls 26 des zentralen Objektfeldpunktes auf den Spiegeln M1 bis M6 beträgt 16,01°, 7,14°, 13,13°, 7,21 °, 0,0° und 0,0°. Die Abfolge der maximalen Einfallswinkel auf den Spiegeln M1 bis M6 beträgt 22,55°, 9,62°, 13,90°, 10,16°, 16,23°, 4,37°. Die Abfolge der Bandbreiten der Einfallswinkel auf den Spiegeln M1 bis M6 beträgt 13,12°, 5,07°, 1,58°, 6,10°, weniger als 16,23° und weniger als 4,37°. Der Arbeitsabstand in der Objektebene 4 beträgt 100 mm. Der Arbeitsabstand in der Bildebene 8 beträgt 40 mm. Das Verhältnis zwischen dem Abstand der Objektebene 4 zum Spiegel M1 und dem Abstand der Objektebene 4 zum Spiegel M2 beträgt 4,25. Zwischen den benachbarten Spiegeln M2 - M3, M4 - M5, M5 - M6 sowie zwischen dem Spiegel M6 und der Bildebene 8 ist jeweils ein Abstand, der größer ist als 40 % des z-Abstandes zwischen der Objektebene 4 und der Bildebene 8. Die Spiegel M1 und M4 haben einen minimalen Abstand der genutzten Reflexionsfläche zum nächstliegenden, diesen Spiegel nicht beaufschlagenden Abbildungsstrahlengang (free board), der kleiner ist als 25 mm.

Die optischen Designdaten der Reflexionsflächen der Spiegel M1 bis M6 der Projektionsoptik 6 können den nachfolgenden Tabellen entnommen werden. Die erste dieser Tabellen gibt zu den optischen Komponenten und zur Aperturblende jeweils den Kehrwert der Scheitelpunktkrümmung (Radius) und einen Abstandswert (Thickness) an, der dem z-Abstand benachbarter Elemente im Strahlengang, ausgehend von der Objektebene, entspricht. Die zweite Tabelle gibt die Koeffizienten $C_j$ der Monome $X^m Y^n$ in der oben angegebenen Freiformflächen-Gleichung für die Spiegel M1 bis M6 an. Am Ende der zweiten Tabelle ist noch der Betrag in mm angegeben, längs dem der jeweilige Spiegel, ausgehend von einem Spiegel-Referenzdesign dezentriert (Y-Decenter) und verdreht (X-Rotation) wurde. Dies entspricht der Parallelverschiebung und der Verkippung beim oben beschriebenen Freiformflächen-Designverfahren. Verschoben wird dabei in y-Richtung und verkippt um die x-Achse. Der Verdrehwinkel ist dabei in Grad angegeben.

| Surface | Radius | Thickness | Mode |
|---------|--------|-----------|------|
| Object | INFINITY | 425,420 | |
| Mirror 1 | 294,947 | -325,420 | REFL |
| Mirror 2 | 681,039 | 690,757 | REFL |
| Mirror 3 | 319,431 | 0,000 | REFL |
| STOP | INFINITY | -244,337 | |
| Mirror 4 | 396,876 | 913,580 | REFL |
| Mirror 5 | 1749,322 | -620,710 | REFL |
| Mirror 6 | 834,214 | 660,710 | REFL |
| Image | INFINITY | 0,000 | |

| Coefficient | M1 | M2 | M3 | M4 | M5 | M6 |
|---|---|---|---|---|---|---|
| K | -8,972907E-01 | -2,722153E-01 | 6,009025E+00 | -2,083103E-01 | 3,438760E+01 | 3,027724E-01 |
| Y | 0,000000E+00 | 0,000000E+00 | 0,000000E+00 | 0,000000E+00 | 0,000000E+00 | 0,000000E+00 |
| X2 | -6,723739E-04 | -9,397624E-05 | -5,616960E-04 | -1,596929E-04 | 9,008585E-06 | 3,436254E-05 |
| Y2 | -7,259542E-04 | -1,245430E-04 | -4,962660E-04 | -1,209634E-04 | 2,711820E-06 | 3,328586E-05 |
| X2Y | -2,611787E-07 | 9,438147E-09 | -6,471824E-07 | -1,397345E-07 | -3,166886E-08 | 4,403654E-10 |
| Y3 | 1,848873E-07 | 2,540415E-08 | 4,939085E-07 | -1,842875E-07 | 5,311486E-09 | 6,726500E-10 |
| X4 | -5,585253E-10 | -3,707750E-11 | -2,414232E-08 | -1,057114E-10 | 9,436063E-10 | 1,898115E-12 |
| X2Y2 | -1,454988E-09 | -1,447610E-10 | -4,434814E-08 | -5,420267E-11 | 1,946694E-09 | 4,974829E-12 |
| Y4 | -5,523329E-09 | -2,392090E-11 | -1,815299E-08 | 4,380159E-10 | 9,997897E-10 | 3,488151E-12 |
| X4Y | -1,364069E-12 | 1,084325E-15 | -3,114225E-11 | -1,197000E-12 | 5,182403E-14 | 4,428526E-16 |
| X2Y3 | 6,732062E-12 | 1,382697E-13 | 9,802932E-11 | -1,950774E-12 | 4,779360E-13 | 1,769320E-16 |
| Y5 | 3,635430E-11 | 0,000000E+00 | 7,767198E-11 | -1,559300E-12 | 3,401358E-13 | 4,373202E-16 |
| X6 | -2,750390E-15 | -9,087823E-17 | -9,415776E-13 | -4,463189E-16 | 1,620585E-15 | 9,932173E-19 |
| X4Y2 | 2,324635E-14 | -5,352295E-17 | -3,094331E-12 | 7,684993E-15 | 5,526453E-15 | 3,332327E-18 |
| X2Y4 | 3,956161E-15 | -2,030722E-16 | -3,217471E-12 | 3,107748E-15 | 5,847027E-15 | 3,759258E-18 |
| Y6 | -1,092384E-13 | -8,567898E-17 | -7,281446E-13 | -7,204126E-16 | 1,552120E-15 | 1,038153E-18 |
| X6Y | -1,179589E-16 | 4,377060E-19 | -1,789065E-16 | -1,451963E-19 | 3,245847E-19 | 1,324484E-22 |
| X4Y3 | -2,570887E-16 | 0,000000E+00 | 1,023466E-14 | -4,269245E-17 | 1,564405E-18 | -9,051915E-22 |
| X2Y5 | -8,917936E-17 | 7,695621E-21 | 1,492914E-14 | -1,217398E-17 | 2,326082E-18 | -1,811267E-22 |
| Y7 | 1,236168E-16 | 0,000000E+00 | 4,771084E-15 | 5,163018E-18 | 7,533041E-19 | 2,904675E-22 |
| X8 | 7,305784E-20 | -2,087892E-22 | -4,992347E-17 | -9,852110E-22 | 5,510114E-21 | -9,878544E-26 |
| X6Y2 | 6,107242E-19 | -8,775175E-22 | -2,298856E-16 | -2,713369E-20 | 2,453885E-20 | 6,254655E-25 |
| X4Y4 | 5,443174E-19 | -2,629666E-22 | -3,296922E-16 | 3,809184E-20 | 3,817638E-20 | 4,270350E-24 |
| X2Y6 | -6,091249E-19 | -8,692919E-23 | -1,689920E-16 | 3,730606E-21 | 2,483560E-20 | 4,657493E-24 |
| Y8 | -2,536724E-19 | 8,059798E-24 | -2,318537E-17 | -7,839829E-21 | 6,692413E-21 | 1,504196E-24 |
| X8Y | 0,000000E+00 | 0,000000E+00 | 0,000000E+00 | 0,000000E+00 | 0,000000E+00 | 0,000000E+00 |
| X6Y3 | 0,000000E+00 | 0,000000E+00 | 0,000000E+00 | 0,000000E+00 | 0,000000E+00 | 0,000000E+00 |
| X4Y5 | 0,000000E+00 | 0,000000E+00 | 0,000000E+00 | 0,000000E+00 | 0,000000E+00 | 0,000000E+00 |
| X2Y7 | 0,000000E+00 | 0,000000E+00 | 0,000000E+00 | 0,000000E+00 | 0,000000E+00 | 0,000000E+00 |
| Y9 | 0,000000E+00 | 0,000000E+00 | 0,000000E+00 | 0,000000E+00 | 0,000000E+00 | 0,000000E+00 |
| X10 | 0,000000E+00 | 0,000000E+00 | 0,000000E+00 | 0,000000E+00 | 0,000000E+00 | 0,000000E+00 |
| X8Y2 | 0,000000E+00 | 0,000000E+00 | 0,000000E+00 | 0,000000E+00 | 0,000000E+00 | 0,000000E+00 |
| X6Y4 | 0,000000E+00 | 0,000000E+00 | 0,000000E+00 | 0,000000E+00 | 0,000000E+00 | 0,000000E+00 |

(fortgesetzt)

| Coefficient | M1 | M2 | M3 | M4 | M5 | M6 |
|---|---|---|---|---|---|---|
| X4Y6 | 0,000000E+00 | 0,000000E+00 | 0,000000E+00 | 0,000000E+00 | 0,000000E+00 | 0,0000001E+00 |
| X2Y8 | 0,000000E+00 | 0,000000E+00 | 0,000000E+00 | 0,000000E+00 | 0,000000E+00 | 0,000000E+00 |
| Y10 | 0,000000E+00 | 0,000000E+00 | 0,000000E+00 | 0,000000E+00 | 0,000000E+00 | 0,000000E+00 |
| Nradius | 1,00E+00 | 1,00E+00 | 1,00E+00 | 1,00E+00 | 1,00E+00 | 1,00E+000 |

| Coefficient | M1 | M2 | M3 | M4 | M5 | M6 |
|---|---|---|---|---|---|---|
| Y-decenter | 68,139 | -264,855 | 176,907 | -28,983 | 101,914 | 97,590 |
| X-rotation | -1,258 | 25,000 | 1,304 | 25,000 | 0,098 | 0,498 |

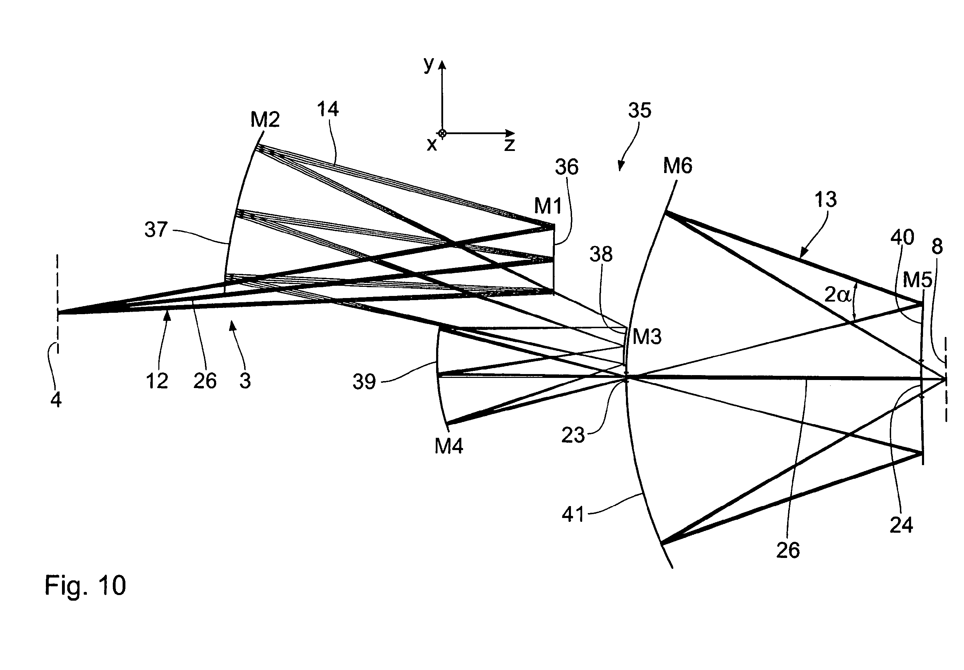

Fig. 10 zeigt eine weitere Ausführung einer Projektionsoptik 35, die anstelle der Projektionsoptik 6 in der Projektionsbelichtungsanlage 1 zum Einsatz kommen kann. Komponenten oder Bezugsgrößen, die denjenigen entsprechen, die vorstehend schon unter Bezugnahme auf die Fig. 1 bis 9 erläutert wurden, tragen die gleichen Bezugsziffern und werden nicht nochmals im Einzelnen diskutiert.

Auch die Projektionsoptik 35 hat insgesamt sechs reflektierende Spiegel, die ausgehend von der Objektebene 4 in der Abfolge des Strahlengangs die Bezugsziffern 36 bis 41 tragen und nachfolgend auch als Spiegel M1 bis M6 bezeichnet werden. Die Spiegel 36 bis 41 haben allesamt Reflektions-Freiformflächen, die nicht durch eine rotationssymmetrische Funktion beschreibbar sind. Die Spiegel 36, 38 und 40 haben eine konvexe und die Spiegel 37, 39, 41 eine konkave Grundform.

Die Projektionsoptik 35 verkleinert um einen Faktor 8. Die Projektionsoptik 36 hat eine bildseitige numerische Apertur von 0,5. Die Dimensionen des Bildfeldes 7 der Projektionsoptik 35 sind genau wie diejenigen der Projektionsoptik 6. Die zwischenbildseitige numerische Apertur beträgt 0,28.

Der erste Spiegel 36 hat eine negative Hauptstrahlwinkelvergrößerung. Der zweite Spiegel 37 hat eine positive Hauptstrahlwinkelvergrößerung. Der dritte Spiegel 38 hat eine negative Hauptstrahlwinkelvergrößerung. Der vierte Spiegel 39 hat, da der Hauptstrahl 26 ab dem vierten Spiegel 39 senkrecht zur Bildebene 8 verläuft, eine unendlich große Hauptstrahlwinkelvergrößerung.

Der Objekt-Bild-Versatz ist bei der Projektionsoptik 35 deutlich größer als bei der Projektionsoptik 6 und beträgt 134 mm.

Der maximale Reflexionswinkel $\alpha$, der auch bei der Projektionsoptik 35 bei den Randstrahlen am fünften Spiegel 40 erreicht wird, beträgt 17 °. Der Quotient aus dem maximalen Reflexionswinkel $\alpha$ und bildseitigen numerischen Apertur beträgt 34 °.

Der freie Arbeitsabstand $d_w$ ist bei der Projektionsoptik 35 mit dem freien Arbeitsabstand der Projektionsoptik 6 vergleichbar. Er beträgt 42 mm.

Optische Daten der Projektionsoptik 35 werden nachfolgend nochmals zusammengefasst:

Die bildseitige numerische Apertur NA beträgt 0,5. Die Größe des Bildfeldes 7 beträgt 1 x 13 mm$^2$. Der verkleinernde Abbildungsmaßstab beträgt 8x. Das Bildfeld 7 ist rechteckig. Die Wellenlänge des Beleuchtungslichts 3 beträgt 13,5 nm. Die Abfolge der optischen Wirkungen der Spiegel M1 bis M6 (negativ N; positiv P) ist PPNPNP. Die Projektionsoptik 35 ist bildseitig nahezu telezentrisch. Eine Aperturblende zur randseitigen Beleuchtungslicht-Begrenzung ist beim Spiegel M3 angeordnet. Der z-Abstand zwischen der Objektebene 4 und der Bildebene 8 beträgt 1.823 mm. Der Objekt-Bild-Versatz beträgt 134 mm. 9,2 % der in den Pupillenebenen ausgeleuchteten Flächen sind obskuriert. Der Hauptstrahlwinkel am zentralen Objektfeldpunkt beträgt 6°. Der Spiegel M1 hat eine Größe (x/y) von 241 x 138 mm$^2$. Der Spiegel M2 hat eine Größe von 377 x 269 mm$^2$. Der Spiegel M3 hat eine Größe von 80 x 75 mm$^2$. Der Spiegel M4 hat eine Größe von 246 x 197 mm$^2$. Der Spiegel M5 hat eine Größe von 352 x 304 mm$^2$. Der Spiegel M6 hat eine Größe von 776 x 678 mm$^2$. Die Abfolge der Hauptstrahl-Einfallswinkel des Hauptstrahls des zentralen Objektfeldpunktes auf den Spiegeln M1 bis M6 beträgt 7,10°, 5,19°, 13,66°, 4,60°, 0,0° und 0,02°. Die Abfolge der maximalen Einfallswinkel auf den Spiegeln M1 bis M6 beträgt 12,23°, 5,53°, 15,43°, 7,33°, 16,98° und 5,51°. Die Abfolge der Bandbreiten der Einfallswinkel auf den Spiegeln M1 bis M6 beträgt 9,93°, 0,78°, 2,98°, 5,27°, weniger als 16,98° und weniger als 5,51°. Der Arbeitsabstand in der Objektebene 4 beträgt 336 mm. Der Arbeitsabstand in der Bildebene 8 beträgt 42 mm. Das Verhältnis zwischen dem Abstand der Objektebene 4 zum Spiegel M1 und dem Abstand der Objektebene 4 zum Spiegel M2 beträgt 3,04. Die Spiegel M1 bis M4 haben einen minimalen Abstand der genutzten Reflexionsfläche zum nächstliegenden, diese Spiegel nicht beaufschlagenden Abbildungsstrahlengang (free board), der kleiner ist als 25 mm. Der Abstand der Objektebene 4 zum Spiegel M1 sowie die Abstände der Spiegelpaare M2 - M3 und M4 - M5 ist größer als 40 % des Abstandes zwischen Objekt- und Bildebene.

Die optischen Designdaten der Reflexionsflächen der Spiegel M1 bis M6 der Projektionsoptik 35 können den nachfolgenden Tabellen entnommen werden, die den Tabellen zur Projektionsoptik nach Fig. 2 entsprechen.

| Surface | Radius | Thickness | Mode |
|---|---|---|---|
| Object | INFINITY | 1023,157 | |
| Mirror 1 | -50610,892 | -686,714 | REFL |
| Mirror 2 | 1171,238 | 828,471 | REFL |

(fortgesetzt)

| Surface | Radius | Thickness | Mode |
|---------|--------|-----------|------|
| Mirror 3 | 318,004 | 0,000 | REFL |
| STOP | INFINITY | -378,086 | |
| Mirror 4 | 413,560 | 994,620 | REFL |
| Mirror 5 | 2997,146 | -612,464 | REFL |
| Mirror 6 | 817,300 | 654,356 | REFL |
| Image | INFINITY | 0,000 | |

| Coeff. | M1 | M2 | M3 | M4 | M5 | M6 |
|---|---|---|---|---|---|---|
| K | 4,156869E+03 | 4,620221E-02 | 9,990462E+00 | -9,081861E-03 | -2,372322E-01 | 6,789706E-03 |
| Y | 0,000000E+00 | 0,000000E+00 | 0,000000E+00 | 0,000000E+00 | 0,000000E+00 | 0,000000E+00 |
| X2 | 4.219939E-05 | -7,203705E-05 | -2,856541E-04 | -1,831594E-04 | -4,114605E-05 | 2,674563E-06 |
| Y2 | -2,952066E-04 | -8.835077E-05 | 1,576757E-04 | -1,812758E-04 | -3,733421E-05 | 7,346415E-06 |
| X2Y | -2,987815E-08 | 1,958263E-08 | 4,843132E-07 | -7,966262E-08 | -5,183892E-08 | -3,629397E-09 |
| Y3 | 5.768104E-07 | 8,430075E-08 | -7,326854E-08 | -9,457440E-08 | -2,814518E-08 | 9,209304E-11 |
| X4 | 2,110770E-10 | 2,081353E-11 | 1,569949E-08 | -3,236129E-10 | 3,542926E-11 | 1,915378E-12 |
| X2Y2 | 3,100857E-10 | -1,622544E-11 | 3,080477E-08 | -6,357050E-10 | 8,409285E-11 | 4,860251E-12 |
| Y4 | -2,322578E-10 | -4,348550E-11 | -9,859142E-09 | -1,882466E-10 | -2,084652E-11 | 6,490959E-14 |
| X4Y | 0,000000E+00 | -7,908907E-15 | 0,000000E+00 | 1,810068E-13 | 1,675236E-13 | -2,002515E-15 |
| X2Y3 | 0,000000E+00 | 1,426458E-14 | 0,000000E+00 | -2,244745E-13 | 1,806451E-13 | -1,799322E-15 |
| Y5 | 0,000000E+00 | -1,321548E-14 | 0,000000E+00 | -2,730307E-13 | -1,337121E-14 | 3,920622E-16 |
| X6 | 0,000000E+00 | 0,000000E+00 | 0,000000E+00 | 0,000000E+00 | 0,000000E+00 | 0,000000E+00 |
| X4Y2 | 0,000000E+00 | 0,000000E+00 | 0,000000E+00 | 0,000000E+00 | 0,000000E+00 | 0,000000E+00 |
| X2Y4 | 0,000000E+00 | 0,000000E+00 | 0,000000E+00 | 0,000000E+00 | 0,000000E+00 | 0,000000E+00 |
| Y6 | 0,000000E+00 | 0,000000E+00 | 0,000000E+00 | 0,000000E+00 | 0,000000E+00 | 0,000000E+00 |
| X6Y | 0,000000E+00 | 0,000000E+00 | 0,000000E+00 | 0,000000E+00 | 0,000000E+00 | 0,000000E+00 |
| X4Y3 | 0,000000E+00 | 0,000000E+00 | 0,000000E+00 | 0,000000E+00 | 0,000000E+00 | 0,000000E+00 |
| X2Y5 | 0,000000E+00 | 0,000000E+00 | 0,000000E+00 | 0,000000E+00 | 0,000000E+00 | 0,000000E+00 |
| Y7 | 0,000000E+00 | 0,000000E+00 | 0,000000E+00 | 0,000000E+00 | 0,000000E+00 | 0,000000E+00 |
| X8 | 0,000000E+00 | 0,000000E+00 | 0,000000E+00 | 0,000000E+00 | 0,000000E+00 | 0,000000E+00 |
| X6Y2 | 0,000000E+00 | 0,00000E+00 | 0,000000E+00 | 0,00000E+00 | 0,000000E+00 | 0,000000E+00 |
| X4Y4 | 0,000000E+00 | 0,000000E+00 | 0,000000E+00 | 0,000000E+00 | 0,000000E+00 | 0,000000E+00 |
| X2Y6 | 0,000000E+00 | 0,000000E+00 | 0,000000E+00 | 0,000000E+00 | 0,000000E+00 | 0,000000E+00 |
| Y8 | 0,000000E+00 | 0,000000E+00 | 0,000000E+00 | 0,000000E+00 | 0,000000E+00 | 0,000000E+00 |
| X8Y | 0,000000E+00 | 0,000000E+00 | 0,000000E+00 | 0,000000E+00 | 0,000000E+00 | 0,000000E+00 |
| X6Y3 | 0,000000E+00 | 0,000000E+00 | 0,000000E+00 | 0,000000E+00 | 0,000000E+00 | 0,000000E+00 |
| X4Y5 | 0,000000E+00 | 0,000000E+00 | 0,000000E+00 | 0,0000000E+00 | 0,000000E+00 | 0,000000E+00 |
| X2Y7 | 0,000000E+00 | 0,000000E+00 | 0,000000E+00 | 0,000000E+00 | 0,000000E+00 | 0,000000E+00 |
| Y9 | 0,000000E+00 | 0,000000E+00 | 0,000000E+00 | 0,000000E+00 | 0,000000E+00 | 0,000000E+00 |
| X10 | 0,000000E+00 | 0,000000E+00 | 0,000000E+00 | 0,000000E+00 | 0,000000E+00 | 0,000000E+00 |
| X8Y2 | 0,000000E+00 | 0,000000E+00 | 0,000000E+00 | 0,000000E+00 | 0,000000E+00 | 0,000000E+00 |
| X6Y4 | 0,000000E+00 | 0,000000E+00 | 0,000000E+00 | 0,000000E+00 | 0,000000E+00 | 0,000000E+00 |

14

(fortgesetzt)

| Coeff. | M1 | M2 | M3 | M4 | M5 | M6 |
|---|---|---|---|---|---|---|
| X4Y6 | 0,000000E+00 | 0,000000E+00 | 0,000000E+00 | 0,000000E+00 | 0,000000E+00 | 0,000000E+00 |
| X2Y8 | 0,000000E+00 | 0,000000E+00 | 0,000000E+00 | 0,000000E+00 | 0,000000E+00 | 0,000000E+00 |
| Y10 | 0,000000E+00 | 0,000000E+00 | 0,000000E+00 | 0,000000E+00 | 0,000000E+00 | 0,000000E+00 |
| Nradius | 1,00E+00 | 1,00E+00 | 1,00E+00 | 1,00E+00 | 1,00E+00 | 1,00E+00 |

| Coefficient | M1 | M2 | M3 | M4 | M5 | M6 |
|---|---|---|---|---|---|---|
| Y-decenter | -242,949 | -116,015 | 15,485 | -94,370 | 162,630 | -15,854 |
| X-rotation | -2,051 | 4,274 | -4,892 | 10,143 | -3,797 | -2,652 |

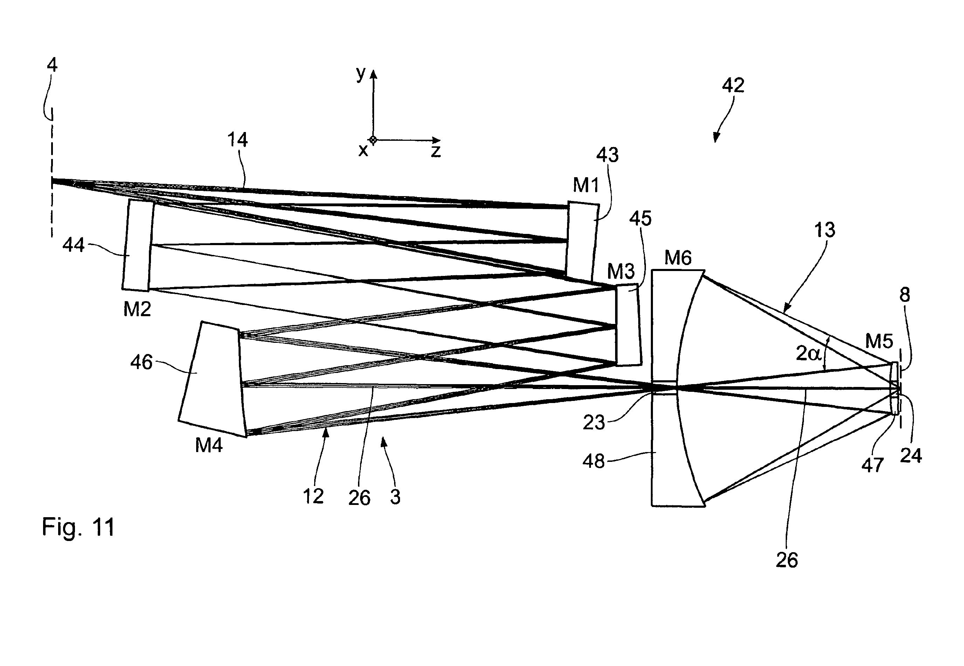

Fig. 11 zeigt eine weitere Ausführung einer Projektionsoptik 42, die anstelle der Projektionsoptik 6 in der Projektionsbelichtungsanlage 1 zum Einsatz kommen kann. Komponenten bzw. Bezugsgrößen, die denjenigen entsprechen, die vorstehend schon unter Bezugnahme auf die Fig. 1 bis 10 erläutert wurden, tragen die gleichen Bezugsziffern und werden nicht nochmals im Einzelnen diskutiert.

Auch die Projektionsoptik 42 hat sechs Reflexionsspiegel, die ausgehend von der Objektebene 4 gemäß ihrer Reihenfolge im Abbildungsstrahlengang mit den Bezugsziffern 43 bis 48 bezeichnet werden. Diese Spiegel werden nachfolgend auch mit M1 bis M6 bezeichnet. Bei der Projektionsoptik 42 sind alle Reflexionsflächen als nicht durch eine rotationssymmetrische Funktion beschreibbare Freiformfläche ausgebildet.

Der erste Spiegel 43 ist konkav, hat aber nur eine sehr geringe Krümmung, sodass er leicht in einen Spiegel mit Grundkrümmung 0 oder in einen konvex gekrümmten Spiegel modifiziert werden kann. Der zweite Spiegel 44 ist konkav und der dritte Spiegel 45 ist konvex gekrümmt. Der vierte Spiegel 46 ist konkav. Der fünfte Spiegel 47 ist konvex. Der sechste Spiegel 48 ist konkav.

Die ersten drei Spiegel 43 bis 45 haben jeweils eine negative Hauptstrahlwinkelvergrößerung. Die Hauptstrahlwinkelvergrößerung des vierten Spiegels 46 ist unendlich groß, da der Hauptstrahl 26 ab seiner Reflexion am vierten Spiegel 46 senkrecht zur Bildebene 8 verläuft.

Die Projektionsoptik 42 hat eine bildseitige numerische Apertur von 0,5. Die Projektionsoptik 42 hat eine zwischenbildseitige numerische Apertur von 0,11.

Der freie Arbeitsabstand $d_w$ beträgt 20 mm bei der Projektionsoptik 42.

Die Projektionsoptik 42 verkleinert um einen Faktor 8.

Die Bildfelddimensionen entsprechen bei der Projektionsoptik 42 denjenigen der Projektionsoptiken 6 und 35.

Der maximale Reflexionswinkel tritt auch bei der Projektionsoptik 42 am fünften Spiegel 47 bei den dortigen äußeren Randstrahlen auf und beträgt $\alpha$ = 16°. Der Quotient aus dem maximalen Reflexionswinkel des Beleuchtungslichts 3 innerhalb der Projektionsoptik 42 und der bildseitigen numerischen Apertur beträgt 32.

Optische Daten der Projektionsoptik 42 werden nachfolgend nochmals zusammengefasst:

Die bildseitige numerische Apertur NA beträgt 0,5. Die Größe des Bildfeldes beträgt 1 x 13 mm². Der verkleinernde Abbildungsmaßstab beträgt 8x. Das Bildfeld 7 ist rechteckig. Die Wellenlänge des Beleuchtungslichts 3 beträgt 13,5 nm. Die Abfolge der optischen Wirkungen der Spiegel M1 bis M6 (negativ N; positiv P) ist PPNPNP. Hauptstrahlen laufen von der Objektebene 4 konvergent in die Projektionsoptik 42 ein. Eine Aperturblende zur randseitigen Beleuchtungslicht-Begrenzung ist beim Spiegel M2 angeordnet. Der z-Abstand zwischen der Objektebene 4 und der Bildebene 8 beträgt 1.700 mm. Der Objekt-Bild-Versatz beträgt 393 mm. 17,0 % der in den Pupillenebenen ausgeleuchteten Flächen sind obskuriert. Die Projektionsoptik 42 hat einen Wellenfrontfehler (rms) in Einheiten der Wellenlänge des Beleuchtungslichts 3 von 0,100. Die Verzeichnung beträgt 16 nm. Die Bildfeldwölbung beträgt 35 nm. Der Hauptstrahlwinkel am zentralen Objektfeldpunkt beträgt 6°. Der Spiegel M1 hat eine Größe (x/y) von 164 x 134 mm². Der Spiegel M2 hat eine Größe von 312 x 170 mm². Der Spiegel M3 hat eine Größe von 147 x 155 mm². Der Spiegel M4 hat eine Größe von 354 x 196 mm². Der Spiegel M5 hat eine Größe von 103 x 96 mm². Der Spiegel M6 hat eine Größe von 457 x 444 mm². Die Abfolge der Hauptstrahl-Einfallswinkel des Hauptstrahls 26 des zentralen Objektfeldpunktes auf den Spiegeln M1 bis M6 beträgt 3,54°, 5,15°, 9,11°, 4,45°, 0,01 ° und 0,01 °. Die Abfolge der maximalen Einfallswinkel auf den Spiegeln M1 bis M6 beträgt 6,18°, 5,62°, 9,80°, 6,85°, 15,94° und 2,36°. Die Abfolge der Bandbreiten der Einfallswinkel auf den Spiegeln M 1 bis M6 beträgt 5,16°, 1,08°, 1,52°, 4,63°, weniger als 15,94° und weniger als 2,38°. Der Arbeitsabstand in der Objektebene 4 beträgt 200 mm. Der Arbeitsabstand in der Bildebene 8 beträgt 20 mm. Das Verhältnis zwischen dem Abstand der Objektebene 4 zum Spiegel M1 und dem Abstand der Objektebene 4 zum Spiegel M2 beträgt 5,07. Die Spiegel M1 und M2 haben einen minimalen Abstand der genutzten Reflexionsfläche zum nächstliegenden, diesen Spiegel nicht beaufschlagenden Abbildungsstrahlengang (free board), der kleiner ist als 25 mm. Der Abstand der Objektebene 4 zum Spiegel M1 sowie die Abstände der Spiegelpaare M1 - M2, M2 - M3, M3 - M4 und M4 - M5 zueinander sind größer als 40 % des Abstandes zwischen der Objekt- und der Bildebene.

Die optischen Designdaten der Reflexionsflächen der Spiegel M1 bis M6 der Projektionsoptik 42 können den nachfolgenden Tabellen entnommen werden, die den vorstehend angeführten Tabellen für die Projektionsoptik 6 nach Fig. 2 entsprechen.

| Surface | Radius | Thickness | Mode |
|---------|--------|-----------|------|
| Object | INFINITY | 1014,317 | |
| Mirror 1 | -2704,152 | -814,317 | REFL |
| Mirror 2 | 531,833 | 0,000 | REFL |
| STOP | INFINITY | 935,139 | |
| Mirror 3 | 491,748 | -718,533 | REFL |
| Mirror 4 | 870,221 1 | 1263,419 | REFL |
| Mirror S | 245,485 | -424,886 | REFL |
| Mirror 6 | 495,477 | 444,861 1 | REFL |
| Image | INFINITY | 0,000 | |

| Coeff. | M1 | M2 | M3 | M4 | M5 | M6 |
|---|---|---|---|---|---|---|
| K | 1,144605E+01 | -9,050341E-01 | -1,089239E+00 | -6,248739E-01 | 2,948620E+00 | 1,091603E-01 |
| Y | 0,000000E+00 | 0,000000E+00 | 0,000000E+00 | 0,000000E+00 | 0,000000E+00 | 0,000000E+00 |
| X2 | 2,857150E-04 | -5,920234E-04 | -2,610462E-04 | -1,368396E-04 | -4,475618E-04 | 1,730506E-05 |
| Y2 | 9,176083E-05 | -8,321210E-04 | -7,892918E-04 | -2,573840E-04 | -4,405714E-04 | 1,563424E-05 |
| X2Y | 7,455682E-07 | -9,307510E-09 | 4,809832E-08 | 3,116002E-08 | 4,341012E-09 | -3,269435E-09 |
| Y3 | 4,605832E-08 | -1,943924E-07 | -2,212409E-07 | 7,169569E-09 | -4,274845E-07 | -4,266065E-09 |
| X4 | -3,659110E-10 | -1,644174E-11 | 8,510237E-10 | 1,713005E-11 | 2,190981E-09 | 1,081076E-11 |
| X2Y2 | -1,689952E-09 | -3,435735E-10 | 6,957800E-12 | -9,146320E-12 | -5,946668E-09 | 2,690241E-11 |
| Y4 | -2,561746E-10 | -6,556489E-10 | 1,590530E-10 | 3,880664E-13 | -1,024229E-08 | -1,427930E-12 |
| X4Y | -3,302144E-12 | -1,451447E-13 | -3,859663E-12 | 4,923124E-14 | -2,729947E-11 | -2,149830E-14 |
| X2Y3 | -2,296129E-12 | 2,463662E-13 | 4,902075E-12 | 4,230604E-14 | -2,255029E-11 | 5,867643E-15 |
| Y5 | 4,869118E-13 | 2,042378E-12 | -5,901335E-13 | -2,503638E-15 | -1,535539E-11 | 1,362505E-14 |
| X6 | 2,532299E-14 | 3,607331E-16 | -3,635906E-15 | -1,910942E-17 | 5,572070E-14 | 1,020771E-17 |
| X4Y2 | 1,050746E-14 | 3,556935E-15 | 6,819544E-14 | 1,635726E-16 | 4,514505E-13 | 3,413101E-17 |
| X2Y4 | 2,215727E-14 | 8,029448E-15 | -1,161921E-14 | -1,548212E-17 | -4,560072E-13 | -1,111206E-17 |
| Y6 | -9,649794E-16 | 7,587037E-15 | 4,555774E-16 | 1,222675E-17 | -3,875470E-13 | -2,539409E-17 |
| X6Y | -1,936844E-16 | -4,478100E-19 | 9,189317E-17 | 3,837055E-19 | -3,689123E-15 | -6,718113E-20 |
| X4Y3 | 5,354672E-17 | 1,140666E-17 | -4,339139E-16 | 2,254755E-19 | -3,854918E-15 | 7,351666E-20 |
| X2Y5 | -3,646598E-17 | 3,260549E-17 | -2,644153E-17 | -8,425001E-20 | 9,184510E-16 | 1,186287E-19 |
| Y7 | 6,063079E-19 | 9,615056E-17 | 1,324974E-18 | -1,850786E-21 | -2,798829E-15 | 6,587133E-20 |
| X8 | 5,617315E-19 | 1,744698E-21 | 8,327575E-19 | 2,970358E-21 | 4,324289E-18 | 5,187555E-23 |
| X6Y2 | 5,094397E-19 | 3,594344E-20 | -9,344050E-19 | 2,069107E-21 | 4,500525E-17 | 3,412692E-23 |
| X4Y4 | -2,079112E-19 | 1,260510E-19 | 1,229358E-18 | -7,743007E-23 | -2,240628E-17 | 6,720118E-23 |
| X2Y6 | -1,595633E-20 | 1,627768E-19 | -2,763971E-20 | 1,708991E-22 | -4,013864E-17 | 2,519384E-23 |
| Y8 | 1,940634E-21 | 4,827783E-19 | 5,031625E-21 | -1,299209E-23 | -6,317984E-18 | -9,073694E-23 |
| X8Y | -3,793003E-21 | 2,116730E-23 | -7,801057E-21 | 1,432927E-23 | -4,043104E-19 | -8,431854E-26 |
| X6Y3 | -6,345560E-22 | 2,804678E-22 | 4,289367E-21 | 2,349972E-24 | -4,743148E-19 | 5,385876E-25 |
| X4Y5 | -1,925796E-22 | 9,316727E-22 | -1,053643E-21 | -3,225767E-25 | 1,860041E-19 | 1,381096E-24 |
| X2Y7 | 8,214685E-23 | 2,388724E-21 | 8,375537E-22 | 2,766796E-25 | 1,013965E-19 | 1,617787E-24 |
| Y9 | 1,703546E-24 | 4.526481 E-21 | -2,966098E-23 | 1,800745E-26 | 3,422243E-22 | 6,810995E-25 |
| X10 | 1,991274E-24 | 5,335545E-26 | 1,741970E-24 | 7,205669E-28 | 0,000000E+00 | -5,791957E-28 |
| X8Y2 | 6,491228E-24 | 1,977752E-24 | 1,571441E-23 | 1,716942E-26 | 0,000000E+00 | -1,179271E-26 |
| X6Y4 | 4,259954E-25 | 7,623140E-24 | -1,086567E-23 | 0,000000E+00 | 0,000000E+00 | -1,124411E-26 |

(fortgesetzt)

| Coeff. | M1 | M2 | M3 | M4 | M5 | M6 |
|---|---|---|---|---|---|---|
| X4Y6 | 8,190088E-25 | 1,642262E-23 | -1,531617E-24 | 0,000000E+00 | 0,000000E+00 | -6,908146E-27 |
| X2Y8 | -3,305040E-26 | 2,718356E-23 | -1,734683E-24 | 4,000570E-29 | 0,000000E+00 | -4,575592E-27 |
| Y10 | -5,699224E-27 | 2,657964E-23 | 5,982496E-26 | 4,841412E-30 | 0,000000E+00 | -1,211899E-27 |
| Nradius | 1,00E+00 | 1,00E+00 | 1,00E+00 | 1,00E+00 | 1,00E+00 | 1,00E+00 |

| Coefficient | M1 | M2 | M3 | M4 | M5 | M6 |
|---|---|---|---|---|---|---|
| Y-decenter | -262,562 | -14,529 | -294,373 | 184,266 | -286,525 | -283,609 |
| X-rotation | -5,767 | -4,073 | 2,602 | -13,391 | 0,685 . | 0,041 |

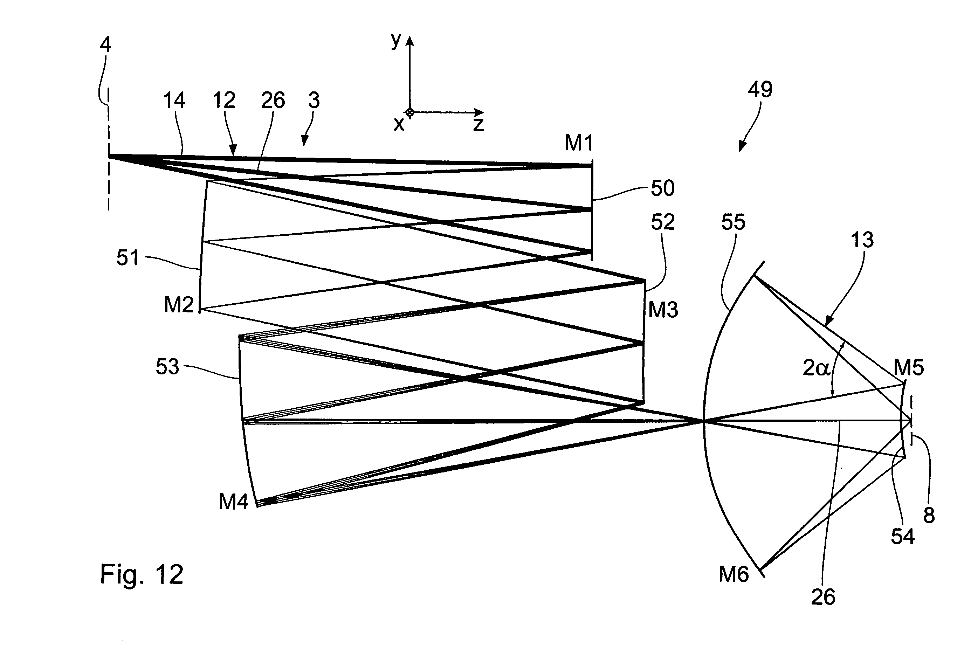

Fig. 12 zeigt eine weitere Ausführung einer Projektionsoptik 49, die anstelle der Projektionsoptik 6 in der Projektionsbelichtungsanlage 1 bei einer UV-Beleuchtung zum Einsatz kommen kann. Komponenten bzw. Bezugsgrößen, die denjenigen entsprechen, die vorstehend schon unter Bezugnahme auf die Fig. 1 bis 11 erläutert wurden, tragen die gleichen Bezugsziffern und werden nicht nochmals im Einzelnen diskutiert.

Auch die Projektionsoptik 49 hat sechs Reflexionsspiegel, die ausgehend von der Objektebene 4 gemäß ihrer Reihenfolge im Abbildungsstrahlengang mit den Bezugsziffern 50 bis 55 bezeichnet werden. Diese Spiegel werden nachfolgend auch mit M1 bis M6 bezeichnet. Bei der Projektionsoptik 49 sind alle Reflexionsflächen als nicht durch eine rotationssymmetrische Funktion beschreibbare Freiformfläche ausgebildet.

Die Abfolge der Spiegel-Grundkrümmungen ist bei der Ausführung nach Fig. 12 genauso wie bei der Ausführung nach Fig. 11. Auch hier ist der erste Spiegel nur sehr schwach gekrümmt und kann daher ohne weiteres zu einem Spiegel mit Grundkrümmung 0 (plane Grundkrümmung) bzw. konvexer Grundkrümmung umgewandelt werden.

Die ersten drei Spiegel 50 bis 52 haben jeweils eine negative Hauptstrahlwinkelvergrößerung. Die Hauptstrahlwinkelvergrößerung des vierten Spiegels 53 ist unendlich groß, da der Hauptstrahl 26 ab seiner Reflexion am vierten Spiegel 53 senkrecht zur Bildebene 8 verläuft.

Die Projektionsoptik 49 hat eine bildseitige numerische Apertur von 0,7. Die Projektionsoptik 49 hat eine zwischenbildseitige numerische Apertur von 0,14.

Der freie Arbeitsabstand $d_w$ beträgt 20 mm bei der Projektionsoptik 49.

Die Projektionsoptik 49 verkleinert um einen Faktor 8.

Die Bildfelddimensionen entsprechen bei der Projektionsoptik 49 denjenigen der Projektionsoptiken 6, 35 und 42. Die Bildfeldgröße beträgt 13 x 1 $mm^2$.

Der maximale Reflexionswinkel tritt auch bei der Projektionsoptik 49 am fünften Spiegel 54 bei den dortigen äußeren Randstrahlen auf und beträgt $\alpha = 23,8°$. Der Quotient aus dem maximalen Reflexionswinkel des Abbildungslichts 3 innerhalb der Projektionsoptik 49 und der bildseitigen numerischen Apertur beträgt 34°.

Optische Daten der Projektionsoptik 49 werden nachfolgend nochmals zusammengefasst:

Die bildseitige numerische Apertur NA beträgt 0,7. Die Größe des Bildfeldes 7 beträgt 1 x 13 $mm^2$. Der verkleinernde Abbildungsmaßstab beträgt 8x. Das Bildfeld 7 ist rechteckig. Die Wellenlänge des Beleuchtungslichts 3 beträgt 193,0 nm. Die Abfolge der optischen Wirkungen der Spiegel M1 bis M6 (negativ N; positiv P) ist PPNPNP. Hauptstrahlen laufen von der Objektebene 4 konvergent in die Projektionsoptik 49 ein. Eine Aperturblende zur randseitigen Beleuchtungslicht-Begrenzung ist beim Spiegel M2 angeordnet. Der z-Abstand zwischen der Objektebene 4 und der Bildebene 8 beträgt 1.700 mm. Der Objekt-Bild-Versatz beträgt 549 mm. 11,6 % der in den Pupillenebenen ausgeleuchteten Flächen sind obskuriert. Die Projektionsoptik 49 hat einen Wellenfrontfehler (rms) in Einheiten der Wellenlänge des Beleuchtungslichts von 0,053. Die Verzeichnung beträgt 400 nm. Die Bildfeldwölbung beträgt 130 nm. Der Hauptstrahlwinkel am zentralen Objektfeldpunkt beträgt 6°. Der Spiegel M1 hat eine Größe (x/y) von 204 x 184 $mm^2$. Der Spiegel M2 hat eine Größe von 652 x 271 $mm^2$. Der Spiegel M3 hat eine Größe von 192 x 260 $mm^2$. Der Spiegel M4 hat eine Größe von 515 x 347 $mm^2$. Der Spiegel M5 hat eine Größe von 162 x 153 $mm^2$. Der Spiegel M6 hat eine Größe von 643 x 619 $mm^2$. Die Abfolge der Hauptstrahl-Einfallswinkel des Hauptstrahls 26 des zentralen Objektfeldpunktes auf den Spiegeln M1 bis M6 beträgt 5,40°, 8,76°, 11,83°, 5,37°, 0,01° und 0,02°. Die Abfolge der maximalen Einfallswinkel auf den Spiegeln M1 bis M6 beträgt 9,70°, 10,06°, 13,22°, 8,94°, 24,01° und 3,62°. Die Abfolge der Bandbreiten der Einfallswinkel auf den Spiegeln M1 bis M6 beträgt 8,23°, 2,81 °, 3,10°, 6,95°, weniger als 24,01 und weniger als 3,62°. Der Arbeitsabstand in der Objektebene 4 beträgt 200 mm. Der Arbeitsabstand in der Bildebene 8 beträgt 20 mm. Das Verhältnis zwischen dem Abstand der Objektebene 4 zum Spiegel M1 und dem Abstand der Objektebene 4 zum Spiegel M2 beträgt 5,11. Die Spiegel M1 bis M3 haben einen minimalen Abstand der genutzten Reflexionsfläche zum nächstliegenden, diese Spiegel nicht beaufschlagenden Abbildungsstrahlengang (free board), der kleiner ist als 25 mm. Der Abstand der Objektebene 4 zum Spiegel M 1 sowie die Abstände der Spiegelpaare M1 - M2, M2 - M3, M3 - M4, M4 - M5 sind größer als 40 % des Abstandes zwischen der Objekt- und der Bildebene.

Die optischen Designdaten der Reflexionsflächen der Spiegel M 1 bis M6 können den nachfolgenden Tabellen entnommen werden, die denjenigen zur oben beschriebenen Projektionsoptik 6 nach Fig. 2 entsprechen.

| Surface | Radius | Thickness | Mode |
|---|---|---|---|
| Object | INFINITY | 1022,710 | |

(fortgesetzt)

| Surface | Radius | Thickness | Mode |
|---------|--------|-----------|------|
| Mirror 1 | -7390,359 | -822,710 | REFL |
| Mirror 2 | 513,847 | 0,000 | REFL |
| STOP | INFINITY | 942,710 | |
| Mirror 3 | 501,145 | -842,710 | REFL |
| Mirror 4 | 843,206 | 1380,024 | REFL |
| Mirror 5 | 578,181 | -417,314 | REFL |
| Mirror 6 | 496,039 | 437,290 | REFL |
| Image | INFINITY | 0,000 | |

| Coeff. | M1 | M2 | M3 | M4 | M5 | M6 |
|---|---|---|---|---|---|---|
| K | 3,481687E+02 | -9,241869E-01 | -7,566344E-01 | -5,019615E-01 | 1,965937E+01 | 1,267270E-01 |
| Y | 0,000000E+00 | 0,000000E+00 | 0,OOOOOOE+00 | 0,OOOOOOE+00 | 0,OOOOOOE+00 | 0,000000E+00 |
| X2 | 6,555377E-04 | -5,511453E-04 | 2,158158E-04 | -1,699472E-04 | 2,894217E-04 | 5,126962E-06 |
| Y2 | 3,295088E-05 | -8,776483E-04 | -9,084036E-04 | -2,883162E-04 | 3,472889E-04 | 1.671956E-05 |
| X2Y | -4,245568E-07 | 3,113324E-08 | 7,395458E-07 | 7.821775E-08 | -4,476295E-07 | -6,764774E-09 |
| Y3 | 1,390824E-08 | -1,918862E-07 | 8,435308E-08 | -2,628080E-08 | 5.451515E-08 | -2,659596E-09 |
| X4 | -3,307013E-10 | -1,191040E-11 | 3,063977E-09 | -3,668514E-11 | 5.377968E-09 | 8,032524E-12 |
| X2Y2 | 3,290269E-09 | -6,921528E-11 | 1,233667E-11 | 1,187534E-10 | 2,249411E-08 | 2,023497E-11 |
| Y4 | -1,463471E-10 | 5,786874E-11 | -6,021292E-12 | -1,106757E-10 | 7,037151E-09 | -5,631157E-12 |
| X4Y | 2,736617E-12 | 4,032934E-15 | -6,984058E-13 | -8,039415E-14 | -1,260298E-12 | -5,006977E-15 |
| X2Y3 | 3,522297E-13 | -1,166725E-13 | -2,454747E-12 | 5,957814E-13 | -1,250078E-11 | -5,698119E-15 |
| Y5 | -2,490692E-13 | 2,590308E-12 | -3,745572E-13 | -1,408338E-14 | -2,442407E-11 | -7,179108E-15 |
| X6 | -1,862455E-14 | 6,281324E-18 | -2,148629E-14 | -6,004672E-17 | 1,997946E-13 | -1,011352E-17 |
| X4Y2 | -7,981936E-14 | 4,496399E-17 | -1,242837E-14 | -6,611499E-16 | 2,590470E-13 | -6,909855E-17 |
| X2Y4 | -4,901925E-14 | -3,029567E-16 | -3,758114E-15 | 9,515240E-16 | -2,673556E-13 | -1,224111E-16 |
| Y6 | 2,434885E-16 | 1,266995E-14 | 1,367511E-16 | 6,466128E-17 | 2,511816E-13 | -4,838450E-17 |
| X6Y | 2,013361E-16 | 1,162633E-19 | 1,149857E-17 | -3,125791E-19 | -1,332065E-15 | -1,469592E-20 |
| X4Y3 | 3,552832E-16 | 1,010087E-18 | -1,441396E-16 | -1,842092E-18 | -2,995433E-15 | -1.117419E-19 |
| X2Y5 | -9,924040E-19 | -2,022287E-19 | -1,400280E-17 | 1,100935E-18 | -2,362122E-15 | -1,093754E-19 |
| Y7 | 1,950700E-18 | -1,249257E-17 | 6,126115E-19 | 3,018212E-20 | 2,029387E-15 | -2,279935E-20 |
| X8 | -1,816371E-19 | 8,241847E-23 | 1,607901E-19 | -2,596493E-23 | 6,322415E-18 | -1,205865E-22 |
| X6Y2 | -1,231881E-18 | 1,602604E-21 | 2,552251E-19 | -7,939427E-22 | 1,136621E-17 | -2,391492E-22 |
| X4Y4 | -1,457234E-19 | 1,343999E-20 | -6,277420E-19 | -2,461049E-21 | -7,995361E-19 | -1,719723E-22 |
| X2Y6 | 5,627869E-19 | 1,086725E-20 | 2,371593E-20 | 9,514060E-22 | -3.361939E-17 | -2,245468E-22 |
| Y8 | 3,626451 E-21 | -2,072810E-20 | -3,369745E-21 | -6,523915E-23 | -4,042492E-18 | -1,070962E-22 |
| X8Y | 1,644403E-21 | 5,521298E-25 | 7,387878E-22 | -4,934005E-26 | -4,739358E-20 | 1,327526E-25 |
| X6Y3 | 2,012939E-21 | 1,839641E-23 | 6,948031E-22 | -5,010250E-25 | -3,213699E-19 | 8,788103E-25 |
| X4Y5 | -9,196304E-22 | 1,613032E-22 | -7,384331 E-22 | -1,017620E-24 | -4,869993E-19 | 1,435145E-24 |
| X2Y7 | -8,444082E-22 | 4,724249E-22 | 1,160142E-22 | 5,807469E-25 | -3,565433E-19 | 5,071171E-25 |
| Y9 | -1,391751E-24 | -1,535204E-22 | -1,540508E-24 | 3,217510E-27 | -5,879640E-20 | -1,515906E-26 |
| X10 | 0,000000E+00 | 0,0000000E+00 | 0,0000000E+00 | 0,000000E+00 | 0,000000E+00 | 0,000000E+00 |
| X8Y2 | 0,000000E+00 | 0,000000E+00 | 0,000000E+00 | 0,000000E+00 | 0,000000E+00 | 0,000000E+00 |
| X6Y4 | 0,000000E+00 | 0,000000E+00 | 0.000000E+00 | 0,000000E+00 | 0,000000E+00 | 0,000000E+00 |

| Coeff. | M1 | M2 | M3 | M4 | M5 | M6 |
|---|---|---|---|---|---|---|
| X4Y6 | 0,000000E+00 | 0,000000E+00 | 0,000000E+00 | 0,000000E+00 | 0,000000E+00 | 0,000000E+00 |
| X2Y8 | 0,000000E+00 | 0,000000E+00 | 0,000000E+00 | 0,000000E+00 | 0,0000000E+00 | 0,000000E+00 |
| Y10 | 0,000000E+00 | 0,000000E+00 | 0,000000E+00 | 0,000000E+00 | 0,000000+00 | 0,000000E+00 |
| Nradius | 1,00E+00 | 1,00E+00 | 1,00E+00 | 1,00E+00 | 1,00E+00 | 1,00E+00 |

| Coefficient | M1 | M2 | M3 | M4 | M5 | M6 |
|---|---|---|---|---|---|---|
| Y-decenter | -197,752 | -67,646 | -76,378 | -20,289 | -432,652 | -422,877 |
| X-rotation | -1,837 | -3,960 | -2,990 | -9,847 | -0,659 | -1,856 |

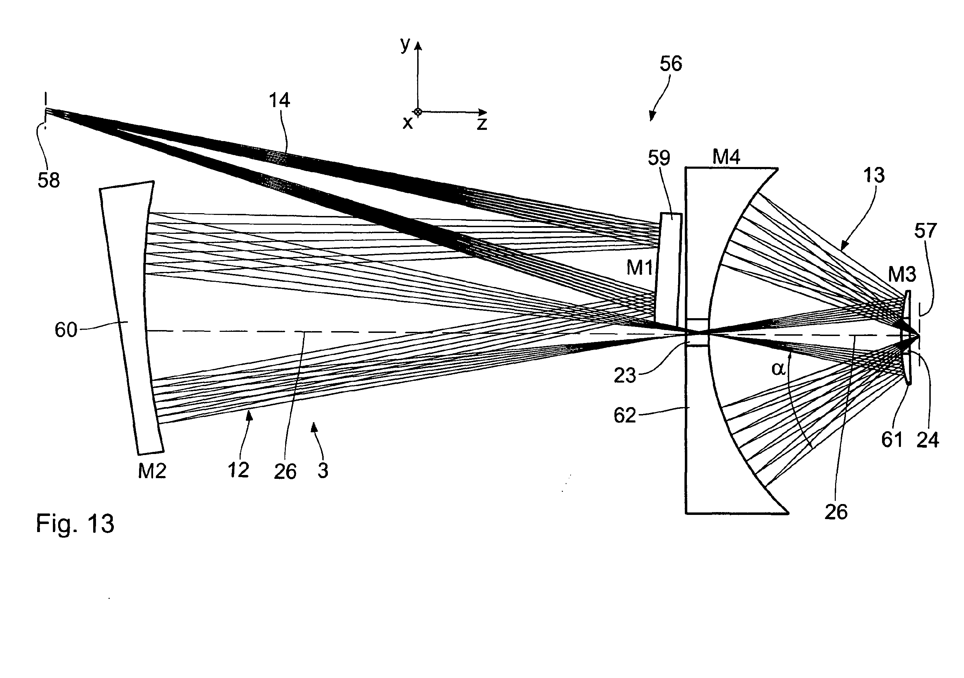

Fig. 13 zeigt ein Mikroskopobjektiv 56, welches zur Inspektion von für die Projektionsbelichtung bzw. Lithographie notwendigen Projektionsmasken oder aber von belichteten Wafern 10 zum Einsatz kommen kann. Das Mikroskopobjektiv bildet eine Mikroskop-Objektebene bzw. Substratebene 57, die im Projektionsbetrieb der Projektionsbelichtungsanlage 1 mit der Bildebene 8 zusammenfällt, auf eine Mikroskop-Bildebene 58 ab. Der Aufbau des Mikroskopobjektivs 56 ähnelt dem z. B. der Projektionsobjekt 6 nach Fig. 2, mit dem Unterschied, dass beim Mikroskopobjektiv 56 im Vergleich zur Projektionsoptik 6 Objekt- und Bildebene vertauscht sind. Das zu untersuchende Objekt liegt also am hochaperturigen Teil des Mikroskopobjektivs 56 und ein Bildaufnahmegerät, zum Beispiel eine CCD-Kamera, liegt am niederaperturigen Teil des Mikroskopobjektivs 56. Im Strahlengang zwischen der Mikroskop-Bildebene 58 und der Substratebene 57 hat das Mikroskopobjektiv 56 insgesamt vier Spiegel 59 bis 62, die in dieser Abfolge beziffert und zudem mit M1 bis M4 bezeichnet sind. Der dritte Spiegel 61 und der vierte Spiegel 62 des Mikroskopobjektivs 56 entsprechen hinsichtlich ihrer Designpositionen und der Durchgangsöffnungen 23, 24 den Spiegeln M5, M6 der vorstehend erläuterten Projektionsoptiken. Die vier Spiegel 59 bis 62 sind als nicht durch eine rotationssymmetrische Funktion beschreibbare Freiformfläche ausgeführt. Alternativ ist es möglich, dass mindestens einer der Spiegel 59 bis 62 eine derartige Freiform-Reflexionsfläche aufweist.

Der erste Spiegel 59 hat eine negative Hauptstrahlwinkelvergrößerung. Der zweite Spiegel 60 hat, da der Hauptstrahl 26 ab dem zweiten Spiegel 60 senkrecht zur Substratebene 57 verläuft, eine unendlich große Hauptstrahlwinkelvergrößerung. Die Hauptstrahlwinkelvergrößerungen des dritten Spiegels 61 und des vierten Spiegels 62 sind entsprechend undefiniert.

Das Mikroskopobjektiv 56 hat eine numerische Apertur von 0,7. Das Mikroskopobjektiv 56 hat eine zwischenbildseitige numerische Apertur von 0,17.

Der maximale Reflexionswinkel $\alpha$ wird beim Mikroskopobjektiv 56 wiederum bei den äußeren Randstrahlen des Spiegels 57 mit der Durchgangsöffnung 24 erreicht und beträgt 24 °. Entsprechend beträgt der Quotient aus diesem Reflexionswinkel und der numerischen Apertur 34 °.

Die Projektionsoptiken 6, 35, 42, 49 sowie das Mikroskopobjektiv 56 können auch bei anderen Wellenlängen des Beleuchtungs- bzw. Abbildungslichts 3 als EUV-Wellenlängen betrieben werden. Beispielsweise ist es möglich, diese Freiform-Designs auch für sichtbare Wellenlängen einzusetzen.

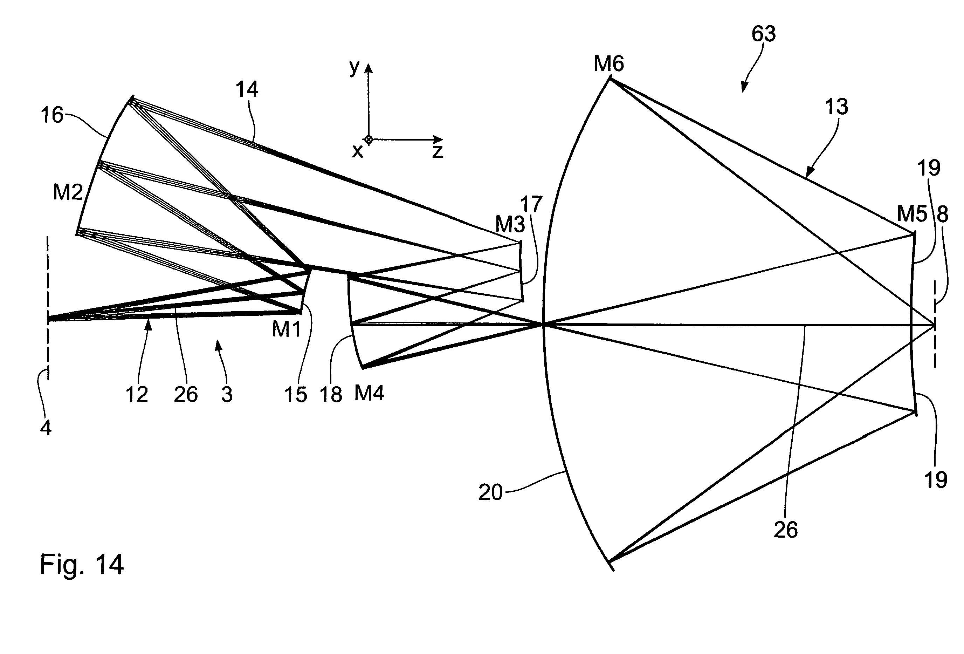

Die Projektionsoptiken 6, 35, 42, 49 sowie das Mikroskopobjektiv 56 sowie die nachfolgend im Zusammenhang mit den Fig. 14 bis 17 noch beschriebenen Optiken können so ausgelegt sein, dass, abgesehen vom Strahlengang im Bereich der Durchgangsöffnungen 23, 24, zwischen den Einzelstrahlen 14 und den jeweils nicht beaufschlagten Spiegeln M1 bis M6 bzw. 59 bis 62 im Falle der gewünschten Reflexionsbeaufschlagung mit Beleuchtungslicht 3 stets ein Abstand eingehalten wird, der kleiner ist als 25 mm, jedoch größer als 1 mm, bevorzugt größer als 5 mm. Dies vereinfacht die baulichen Anforderungen an die jeweilige Optik.

Fig. 14 zeigt eine weitere Ausführung einer Projektionsoptik 63, die anstelle der Projektionsoptik 6 in der Projektionsbelichtungsanlage 1 wiederum bei einer EUV-Beleuchtung zum Einsatz kommen kann. Komponenten bzw. Bezugsgrößen, die denjenigen entsprechen, die vorstehend schon unter Bezugnahme auf die Projektionsoptiken 6, 35, 42, 49 der Fig. 1 bis 12 erläutert wurden, tragen die gleichen Bezugsziffern und werden nicht nochmals im Einzelnen diskutiert. Nachfolgend werden nur die wesentlichen Unterschiede der Projektionsoptik 63 zu den vorstehend schon erläuterten Projektionsoptiken 6, 35, 42, 49 behandelt.

Die optischen Daten der Projektionsoptik 63 sind wie folgt:

Die bildseitige numerische Apertur NA beträgt 0,6. Die Größe des Bildfeldes 7 beträgt 1 x 13 mm$^2$. Der verkleinernde Abbildungsmaßstab beträgt 8x. Das Bildfeld 7 ist rechteckig. Die Wellenlänge des Beleuchtungslichts 3 beträgt 13,5 nm. Die Projektionsoptik 63 hat sechs Spiegel M1 bis M6. Die Abfolge der optischen Wirkungen der Spiegel M1 bis M6 (negativ N; positiv P) ist NPNPNP. Zwischen den Spiegeln M4 und M5 liegt das einzige Zwischenbild der Projektionsoptik 63 vor. Hauptstrahlen laufen von der Objektebene 4 konvergent in die Projektionsoptik 63 ein. Eine Aperturblende zur randseitigen Beleuchtungslicht-Begrenzung ist beim Spiegel M3 angeordnet. Der z-Abstand zwischen der Objektebene 4 und der Bildebene 8 beträgt 1.500 mm. Der Objekt-Bild-Versatz beträgt 7,07 mm. 5,7 % der in den Pupillenebenen ausgeleuchteten Flächen sind obskuriert. Die Projektionsoptik 63 hat einen Wellenfrontfehler (rms) in Einheiten der Wellenlänge des Beleuchtungslichts 3 von 0,034. Die Verzeichnung beträgt 15 nm. Die Bildfeldwölbung beträgt 10 nm. Der Hauptstrahlwinkel am zentralen Objektfeldpunkt beträgt 5,9°. Der Spiegel M1 hat eine Größe (x/y) von 126 x 73 mm$^2$. Der Spiegel M2 hat eine Größe von 339 x 164 mm$^2$. Der Spiegel M3 hat eine Größe von 100 x 96 mm$^2$. Der Spiegel M4 hat eine Größe von 196 x 150 mm$^2$. Der Spiegel M5 hat eine Größe von 307 x 298 mm$^2$. Der

Spiegel M6 hat eine Größe von 814 x 806 mm$^2$. Die Abfolge der Hauptstrahl-Einfallswinkel des Hauptstrahls 26 des zentralen Objektfeldpunktes auf den Spiegeln M1 bis M6 beträgt 18,61°, 8,76°, 15,44°, 8,53°, 0,00° und 0,00°. Die Abfolge der maximalen Einfallswinkel auf den Spiegeln M1 bis M6 beträgt 26,60°, 11,80°, 15,98°, 12,32°, 20,14° und 5,11 °. Die Abfolge der Bandbreiten der Einfallswinkel auf den Spiegeln M1 bis M6 beträgt 16,06°, 6,30°, 1,03°, 7,87°, weniger als 20,14° und weniger als 5,11°. Die Abfolge der Hauptstrahlwinkelvergrößerungen der Spiegel M 1 bis M3 (negativ N; positiv P) ist NPN. Der Arbeitsabstand in der Objektebene 4 beträgt 102 mm. Der Arbeitsabstand in der Bildebene 8 beträgt 40 mm. Das Verhältnis zwischen dem Abstand der Objektebene 4 zum Spiegel M1 und dem Abstand der Objektebene 4 zum Spiegel M2 beträgt 4,13. Die Spiegel M1 und M4 haben einen minimalen Abstand der genutzten Reflexionsflächen zum nächstliegenden, diesen Spiegel nicht beaufschlagenden Abbildungsstrahlengang (free board) der kleiner ist als 25 mm. Die Abstände der Spiegelpaare M2 - M3 - M4 - M5, M5 - M6 sowie der Abstand des Spiegels M6 zur Bildebene 8 sind kleiner als 40 % des Abstandes der Objektebene 4 zur Bildebene 8.

Die optischen Designdaten der Reflexionsflächen der Spiegel M1 bis M6 der Projektionsoptik 63 können den nachfolgenden Tabellen entnommen werden, die den Tabellen zur Projektionsoptik 6 nach Fig. 2 entsprechen.

| Surface | Radius | Thickness | Mode |
|---|---|---|---|
| Object | INFINITY | 423,049 | |
| Mirror 1 | 291,429 | -320,693 | REFL |
| Mirror 2 | 682,291 | 698,472 | REFL |
| Mirror 3 | 327,553 | 0,000 | REFL |
| STOP | INFINITY | -250,085 | |
| Mirror 4 | 398,721 | 909,257 | REFL |
| Mirror 5 | 1753,638 | -620,641 | REFL |
| Mirror 6 | 834,258 | 660,641 | REFL |
| Image | INFINITY | 0,000 | |

| Coeff. | M1 | M2 | M3 | M4 | M5 | M6 |
|---|---|---|---|---|---|---|
| K | -9,797768E-01 | -2,654407E-01 | 3,633187E+00 | -2,607926E-01 | 3,367484E+01 | 3,003345E-01 |
| Y | 0,000000E+00 | 0,000000E+00 | 0,000000E+00 | 0,000000E+00 | 0,000000E+00 | 0,OOOOOOE+00 |
| X2 | -6,757907E-04 | -9,897313E-05 | -6,055737E-04 | -1,712326E-04 | 8,316524E-06 | 3,449849E-05 |
| Y2 | -6,711750E-04 | -1,286106E-04 | -5,464279E-04 | -1,127817E-04 | 1,666997E-06 | 3,303139E-05 |
| X2Y | -1,718471E-07 | 8,106102E-09 | 3,559721E-08 | -1,625547E-07 | -3,433987E-08 | -5,594447E-10 |
| Y3 | 8,441316E-08 | 2,066449E-08 | 2,993241E-07 | -2,438542E-07 | -5,340235E-09 | 2,648587E-10 |
| X4 | -4,235340E-10 | -6,184068E-11 | -1,590557E-08 | -5,148175E-11 | 9,293663E-10 | 1,431375E-12 |
| X2Y2 | -2,833593E-10 | -1,232739E-10 | -2,294580E-08 | 6,076202E-11 | 1,884838E-09 | 4,501941E-12 |
| Y4 | -6,283000E-09 | -1,538541E-11 | -7,807703E-09 | 4,592939E-10 | 9,735975E-10 | 3,169895E-12 |
| X4Y | 5,216941E-13 | 1,355055E-14 | -4,125213E-11 | -5,236068E-13 | -6,108177E-14 | 4,760532E-16 |
| X2Y3 | -5,462082E-12 | 1,539145E-13 | 5,882108E-11 | -7,857103E-13 | 5,606699E-14 | -1,383433E-15 |
| Y5 | 3.841515E-11 | -4,826907E-15 | 6,536341E-11 | -1,173929E-12 | 6,122980E-14 | -1,198686E-15 |
| X6 | -2.961655E-14 | -5,649609E-16 | -5.319482E-13 | 1,037860E-15 | 1,575126E-15 | 5,280799E-19 |
| X4Y2 | -6,986732E-15 | 1,523728E-17 | -1,125923E-12 | 4,138161E-15 | 5,066143E-15 | 3,110524E-18 |
| X2Y4 | 5,755669E-14 | -1,992110E-16 | -9,962349E-13 | -5,642387E-15 | 5,364157E-15 | 3,810873E-18 |
| Y6 | -7,476803E-14 | -3,652597E-17 | -1,721064E-13 | -2,311791E-16 | 1,498586E-15 | 9,716738E-19 |
| X6Y | 8,136042E-16 | 1,347989E-18 | 1,560712E-15 | -3,431381E-17 | 1,006276E-18 | -1,255738E-22 |
| X4Y3 | 1,102636E-17 | 9,697709E-22 | 2,841374E-15 | -6,361244E-17 | -5,733345E-19 | -1,261922E-21 |
| X2Y5 | 1,331907E-16 | -1,331590E-20 | 2,163234E-15 | 2,657780E-17 | -1,545019E-18 | -3,386914E-22 |
| Y7 | 3,093492E-17 | 0,000000E+00 | 2,304330E-15 | 1,049058E-19 | 3,738255E-20 | 1,710371E-22 |
| X8 | 1,506508E-18 | 5,810497E-21 | 1,133674E-17 | 6,127110E-21 | 3,186325E-21 | 1,107455E-24 |
| X6Y2 | -1,013674E-17 | 6,179938E-22 | -5,629342E-17 | 3,657501E-19 | 2,411205E-20 | 2,133982E-24 |
| X4Y4 | -1,366007E-18 | -3,261229E-22 | -8,750490E-17 | 4,374764E-19 | 3,931624E-20 | 4,739463E-24 |
| X2Y6 | -1.047171E-18 | -1,345299E-22 | -1,260161E-17 | -6,674633E-20 | 2,052091E-20 | 3,396921E-24 |
| Y8 | -9,482484E-19 | -7,567828E-23 | -3,447928E-18 | -3,054349E-21 | 6,173346E-21 | 9,678311E-25 |
| X8Y | -5,877725E-20 | -1,822355E-23 | -4,253705E-19 | -1,365311E-22 | -1,472429E-23 | 2,361551 E-27 |
| X6Y3 | 4,790823E-20 | -3,116535E-24 | -6,154610E-19 | -1,894833E-21 | -3,675978E-23 | 1,990878E-27 |
| X4Y5 | 8,584886E-21 | -9,980946E-26 | 2,375768E-19 | -1,854722E-21 | -2,816555E-23 | -4,075851E-27 |
| X2Y7 | -1,694967E-20 | -4,093120E-26 | 7,589434E-19 | -4,379199E-23 | -6,563563E-24 | -5,800819E-27 |
| Y9 | 2,326792E-21 | 0,000000E+00 | 1,307119E-19 | -2,515286E-23 | 2,606727E-24 | -1,858737E-28 |
| X10 | 1,401272E-22 | 6,373969E-27 | 2,615474E-22 | 2,577682E-25 | 4,145747E-26 | -1,274796E-31 |
| X8Y2 | 3,458862E-22 | 1,154175E-26 | -7,752079E-21 | 5,165996E-25 | 1,524801E-25 | -2,154682E-30 |
| X6Y4 | -6,486950E-23 | -8,465791E-29 | -1,437881E-20 | 3,499212E-24 | 2,916563E-25 | 4,867171E-30 |

(fortgesetzt)

| Coeff. | M1 | M2 | M3 | M4 | M5 | M6 |
|---|---|---|---|---|---|---|
| X4Y6 | -2,005656E-23 | -2,584491E-28 | -1,352099E-21 | 3,142335E-24 | 3,587746E-25 | 1,828109E-29 |
| X2Y8 | 6,434247E-23 | -5,536465E-29 | 7,452494E-21 | 3,871445E-25 | 2,307038E-25 | 1,576792E-29 |
| Y10 | 1,692634E-24 | 0,000000E+00 | 1,578385E-21 | 1,350146E-25 | 2,372597E-26 | 1,664967E-30 |
| Nradius | 1,00E+00 | 1,00E+00 | 1,00E+00 | 1,00E+00 | 1,00E+00 | 1,00E+00 |

| Coefficient | M1 | M2 | M3 | M4 | M5 | M6 |
|---|---|---|---|---|---|---|
| Y-decenter | 72,424 | -276,725 | 184,767 | -26,657 | 97,145 | 97,828 |
| X-rotation | -3,803 | 24,855 | 1,633 | 24,917 | 0,012 | -0,062 |

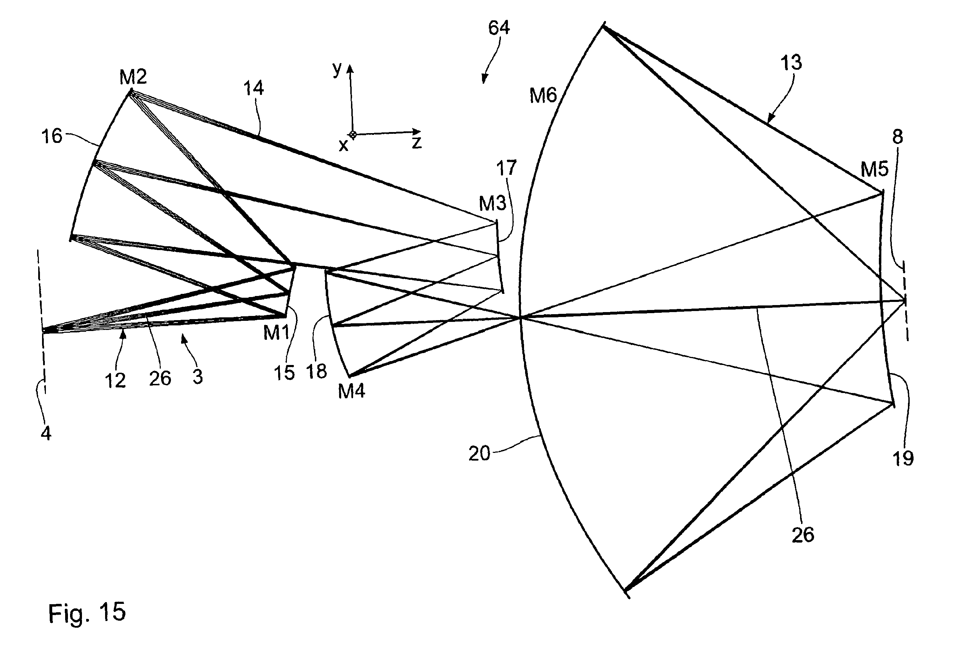

Fig. 15 zeigt eine weitere Ausführung einer Projektionsoptik 64, die anstelle der Projektionsoptik 6 in der Projektionsbelichtungsanlage 1, wiederum bei einer EUV-Beleuchtung zum Einsatz kommen kann. Komponenten bzw. Bezugsgrößen, die denjenigen entsprechen, die vorstehend schon unter Bezugnahme auf die Fig. 1 bis 12 bzw. 14 erläutert wurden, tragen die gleichen Bezugsziffern und werden nicht nochmals im Einzelnen diskutiert.

Die optischen Daten der Projektionsoptik 64 werden nachfolgend zusammengefasst:

Die bildseitige numerische Apertur NA beträgt 0,7. Die Größe des Bildfeldes 7 beträgt 1 x 13 mm². Der verkleinernde Abbildungsmaßstab beträgt 8x. Das Bildfeld 7 ist rechteckig. Die Wellenlänge des Beleuchtungslichts 7 beträgt 13,5 nm. Die Projektionsoptik 64 hat sechs Spiegel M1 bis M6. Die Abfolge der optischen Wirkungen der Spiegel M1 bis M6 (negativ N; positiv P) ist NPNPNP. Zwischen den Spiegeln M4 und M5 liegt die einzige Zwischenbildebene der Projektionsoptik 64. Hauptstrahlen laufen von der Objektebene 4 konvergent in die Projektionsoptik 64 ein. Eine Aperturblende zur randseitigen Beleuchtungslicht-Begrenzung ist beim Spiegel M3 angeordnet. Der z-Abstand zwischen der Objektebene 4 und der Bildebene 8 beträgt 1.483 mm. Der Objekt-Bild-Versatz beträgt 13,86 mm. 6,4 % der in den Pupillenebenen ausgeleuchteten Flächen sind obskuriert. Die Projektionsoptik 64 hat einen Wellenfrontfehler (rms) in Einheiten der Wellenlänge des Beleuchtungslichts 3 von 0,062. Die Verzeichnung beträgt 18 nm. Die Bildfeldwölbung beträgt 10 nm. Der Hauptstrahlwinkel am zentralen Objektfeldpunkt beträgt 5,9°. Der Spiegel M1 hat eine Größe (x/y) von 134 x 84 mm². Der Spiegel M2 hat eine Größe von 365 x 174 mm². Der Spiegel M3 hat eine Größe von 121 x 114 mm². Der Spiegel M4 hat eine Größe von 220 x 176 mm². Der Spiegel M5 hat eine Größe von 363 x 354 mm². Der Spiegel M6 hat eine Größe von 956 x 952 mm². Die Abfolge der Hauptstrahl-Einfallswinkel des Hauptstrahls 26 des zentralen Objektfeldpunktes auf den Spiegeln M1 bis M6 beträgt 20,86°, 10,26°, 17,50°, 9,84°, 0,00° und 0,00°. Die Abfolge der maximalen Einfallswinkel auf den Spiegeln M1 bis M6 beträgt 29,83°, 13,67°, 18,09°, 14,40°, 24,60° und 5,70°. Die Abfolge der Bandbreiten der Einfallswinkel auf den Spiegeln M1 bis M6 beträgt 18,23°, 7,18°, 1,06°, 9,50°, weniger als 16,98° und weniger als 5,51°. Die Abfolge der Hauptstrahlwinkelvergrößerungen der Spiegel M 1 bis M3 (negativ N; positiv P) ist NPN. Der Arbeitsabstand in der Objektebene 4 beträgt 100 mm. Der Arbeitsabstand in der Bildebene 8 beträgt 40 mm. Das Verhältnis zwischen dem Abstand der Objektebene zum Spiegel M1 und dem Abstand der Objektebene 4 zum Spiegel M2 beträgt 4,13. Die Spiegel M1 und M4 haben einen minimalen Abstand der genutzten Reflexionsfläche zum nächstliegenden, diese Spiegel nicht beaufschlagenden Abbildungsstrahlengang (free board), der kleiner ist als 25 mm. Die Abstände der Spiegelpaare M2 - M3, M4 - M5, M5 - M6 und der Abstand des Spiegels M6 zur Bildebene 8 sind größer als 40 % des Abstandes der Objektebene 4 zur Bildebene 8.

Die optischen Designdaten der Reflexionsflächen der Spiegel M1 bis M6 der Projektionsoptik 64 können den nachfolgenden Tabellen entnommen werden, die den Tabellen zur Projektionsoptik 6 nach Fig. 2 entsprechen.

| Surface | Radius | Thickness | Mode |
|---|---|---|---|
| Object | INFINITY | 413,264 | |
| Mirror 1 | 289,172 | -313,264 | REFL |
| Mirror 2 | 680,603 | 689,549 | REFL |
| Mirror 3 | 333,217 | 0,000 | REFL |
| STOP | INFINITY | -255,285 | |
| Mirror 4 | 400,498 | 908,331 | REFL |
| Mirror 5 | 1757,579 | -620,526 | REFL |
| Mirror 6 | 834,338 | 660,526 | REFL |
| Image | INFINITY | 0,000 | |

| Coeff. | M1 | M2 | M3 | M4 | M5 | M6 |
|---|---|---|---|---|---|---|
| K | -1,030576E+00 | -2,635304E-01 | 4,190202E+00 | -2,532242E-01 | 3,343958E+01 | 2,989093E-01 |
| Y | 0,000000E+00 | 0,000000E+00 | 0,000000E+00 | 0,000000E+00 | 0,000000E+00 | 0,000000E+00 |
| X2 | -6,535480E-04 | -9,651094E-05 | -6,315149E-04 | -1,860891E-04 | 6.210957E-06 | 3,467308E-05 |
| Y2 | -6,703313E-04 | -1,285085E-04 | -5,894828E-04 | -1,055800E-04 | 3,848982E-07 | 3,293719E-05 |
| X2Y | -1,109153E-07 | 9,418989E-09 | 5.191842E-07 | -1,736028E-07 | -3.604297E-08 | -1,901465E-09 |
| Y3 | -1,849968E-07 | 1,804370E-08 | 1,052875E-08 | -3,008104E-07 | -1,255871E-08 | -7,306681E-10 |
| X4 | -3,455652E-10 | -6,435672E-11 | -1,959503E-08 | -1,181975E-10 | 9,251123E-10 | 9,219996E-13 |
| X2Y2 | 8.907151E-11 | -1,169230E-10 | -2,854507E-08 | 3,223161E-11 | 1,828013E-09 | 3,292930E-12 |
| Y4 | -6,694084E-09 | -1,746102E-11 | -1,100719E-08 | 5,508116E-10 | 9,590508E-10 | 2,723624E-12 |
| X4Y | -6,682583E-13 | 6,169836E-15 | -4,579394E-11 | -4,554803E-13 | -1,075058E-13 | -9,398044E-17 |
| X2Y3 | -3,764773E-12 | 1,837427E-13 | 8,072483E-13 | -1,108837E-12 | 1,733346E-14 | -1,372960E-15 |
| Y5 | 3,946729E-11 | 1,501209E-15 | 4,522011E-11 | -1,761285E-12 | 5,059303E-14 | -1,418313E-15 |
| X6 | -2,950759E-14 | 5,555342E-16 | -4,772179E-13 | 2,049340E-16 | 1,249728E-15 | 6,302080E-19 |
| X4Y2 | -3,981976E-14 | 7,309283E-17 | -1,369581E-12 | 2,599849E-15 | 4,180701E-15 | 1,406199E-18 |
| X2Y4 | 6,662007E-14 | -1,567936E-16 | -1,344358E-12 | -6,991042E-15 | 4,324958E-15 | 9,589967E-19 |
| Y6 | -6,296271E-14 | 5,254697E-18 | -3,274586E-13 | -1,365187E-15 | 1,317067E-15 | 4,531531E-19 |
| X6Y | 9,572567E-16 | -4,550481E-18 | -2,349696E-17 | -2,327425E-17 | 1,147404E-18 | -5,815673E-22 |
| X4Y3 | 1,729544E-15 | -5,168321E-21 | -6,343836E-16 | -6,844084E-17 | 1,396280E-18 | -1,101533E-21 |
| X2Y5 | 2,003151E-16 | -1,086056E-20 | 7,211912E-17 | 3,651614E-17 | 2,129037E-19 | -6,825077E-22 |
| Y7 | -6,259873E-17 | 0,000000E+00 | 1,314567E-15 | 4,966906E-18 | 4,944608E-20 | -3,674224E-22 |
| X8 | 8,514832E-19 | 5.499001E-21 | -1,315946E-17 | 1.431441E-20 | 5.935619E-21 | 2,351396E-25 |
| X6Y2 | -1,930952E-17 | 1,021410E-20 | -3,809772E-17 | 2,893679E-19 | 2.146809E-20 | 1.941034E-24 |
| X4Y4 | -2,629657E-17 | -5,261250E-22 | -4,023107E-17 | 4,708584E-19 | 2.844557E-20 | 3,285122E-24 |
| X2Y6 | -7,113538E-18 | -2.063344E-22 | -3,710671E-17 | -1,202904E-19 | 1,718587E-20 | 6,947595E-25 |
| Y8 | -6,688170E-19 | -9,807129E-23 | -1,246348E-17 | -1,007426E-20 | 5,947625E-21 | 5,352899E-25 |
| X8Y | -2,167642E-20 | -1,475245E-23 | -4,375451E-20 | -3,593805E-22 | -6,272355E-24 | -6,386618E-29 |
| X6Y3 | 1,577014E-19 | -7,541034E-24 | 1,407216E-21 | -1,733010E-21 | -1,503182E-23 | -2,378905E-27 |
| X4Y5 | 1,475476E-19 | 2,828164E-25 | 2,164416E-19 | -1,819583E-21 | -5,558949E-24 | -4,818316E-27 |
| X2Y7 | 2,386767E-20 | 2,916090E-26 | 4.037031 E-19 9 | 1.506408E-22 | 1,500592E-23 | -2,782420E-27 |
| Y9 | 2,686189E-21 | -3,808616E-26 | 1,365101E-19 | 2,759985E-23 | 9,373049E-24 | 3,697377E-29 |
| X10 | 6,880195E-23 | 4,028878E-27 | -3,684363E-22 | 3,684053E-25 | 8,977447E-27 | 1,376079E-31 |
| X8Y2 | 1,028653E-22 | 7,179210E-27 | -5,946953E-21 | 1,412893E-24 | 6,817863E-26 | -3,343096E-30 |
| X6Y4 | -4,423830E-22 | -2,428875E-28 | -1,431825E-20 | 3,370257E-24 | 1,794556E-25 | -8,790772E-30 |

(fortgesetzt)

| Coeff. | M1 | M2 | M3 | M4 | M5 | M6 |
|---|---|---|---|---|---|---|
| X4Y6 | -2.798064E-22 | 1,268239E-28 | -9,083451E-21 | 2,674694E-24 | 2,401259E-25 | -2,285964E-30 |
| X2Y8 | -1,113049E-23 | -1,289425E-30 | 4,131039E-22 | -1,824536E-27 | 1.599496E-25 | 5,901778E-30 |
| Y10 | 1,536113E-24 | 0,000000E+00 | 9,866128E-22 | 9,363641E-28 | 1,894848E-26 | 1.501949E-30 |
| Nradius | 1,00E+00 | 1,00E+00 | 1,00E+00 | 1,00E+00 | 1,00E+00 | 1,00E+00 |

| Coefficient | M1 | M2 | M3 | M4 | M5 | M6 |
|---|---|---|---|---|---|---|
| Y-decenter | 76,368 | -281,911 | 194,003 | -24,759 | 94,122 | 96,437 |
| X-rotation | -6,675 | 24,349 | 2,204 | 25,034 | -0,109 | -0,453 |

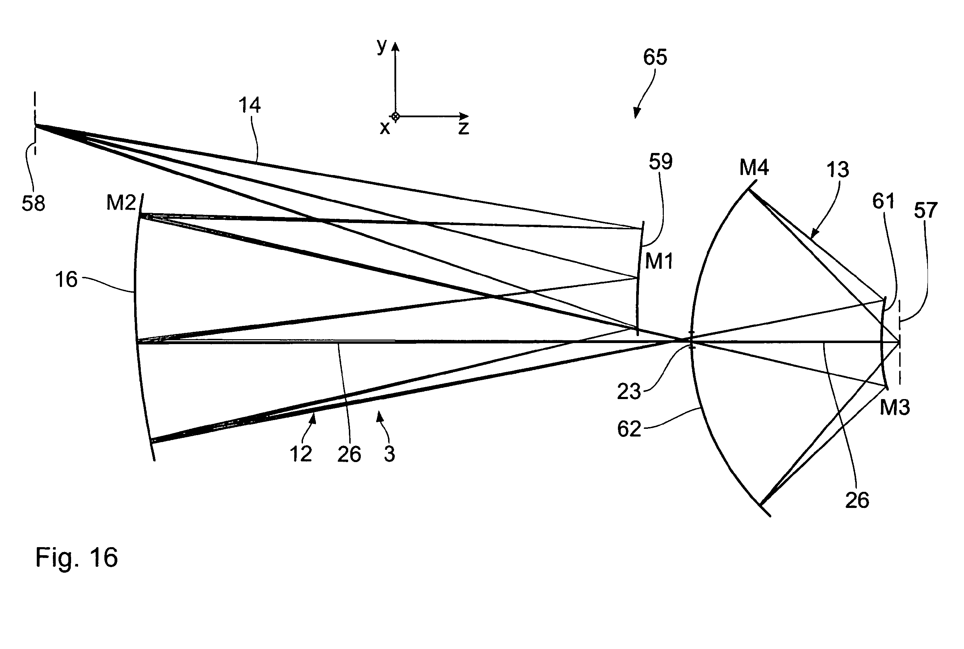

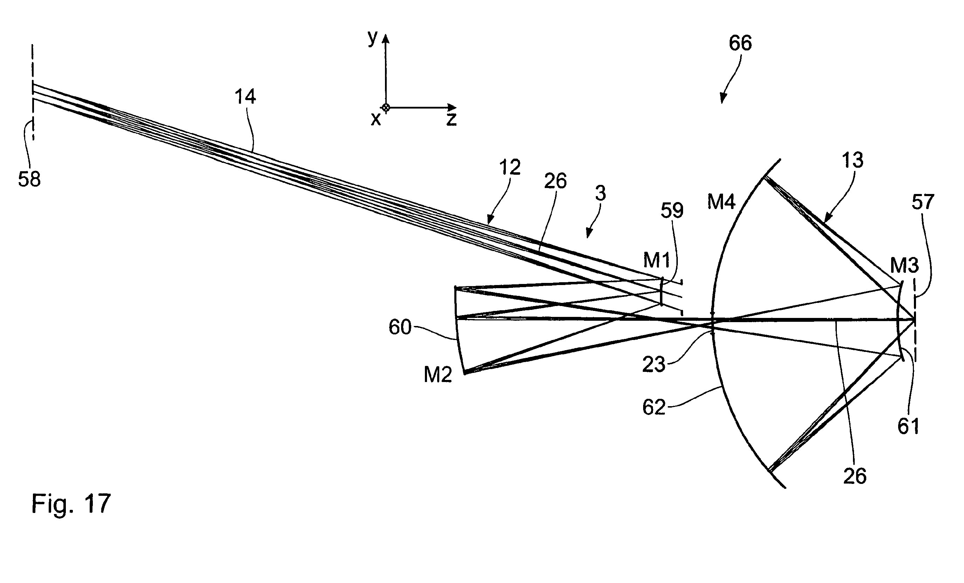

Nachfolgend werden noch optische Daten zu zwei weiteren Mikroskopobjektiven 65, 66 zusammengefasst, die wie das Mikroskopobjektiv 56 zur Inspektion von für die Projektionsbelichtung bzw. Lithographie notwendigen Projektionsmasken oder aber von belichteten Wafern zum Einsatz kommen können. Diese beiden weiteren Mikroskopobjektive 65, 66 sind in den Fig. 16 und 17 dargestellt. Der grundsätzliche Vier-Spiegel-Aufbau dieser beiden weiteren Mikroskopobjektive 65, 66 entspricht dem nach Fig. 13.

Komponenten, die bei diesen weiteren Mikroskopobjektiven 65, 66 denen entsprechen, die vorstehend schon im Zusammenhang mit dem Mikroskopobjektiv 56 nach Fig. 13 erläutert wurden, tragen die gleichen Bezugsziffern bzw. Bezeichnungen.

Das erste dieser beiden weiteren Mikroskopobjektive 65, 66, das Mikroskopobjektiv 65, das in der Fig. 16 dargestellt ist, hat eine objektseitige numerische Apertur von 0,8. Die Größe des quadratischen Objektfeldes beträgt 0,8 x 0,8 mm$^2$. Der vergrößernde Abbildungsmaßstab beträgt 10x. Die Wellenlänge des Beleuchtungslichts 3 beträgt 193,0 nm. Auch eine andere Beleuchtungslicht-Wellenlänge ist möglich, zum Beispiel eine sichtbare Wellenlänge oder eine EUV-Wellenlänge. Die Abfolge der optischen Wirkungen der Spiegel M1 bis M4 (negativ N; positiv P) ist NPNP. Das einzige Zwischenbild liegt zwischen den Spiegeln M2 und M3 und zwar am Ort der Durchgangsbohrung 23 im Spiegel M4. Hauptstrahlen laufen von der Mikroskop-Bildebene 58 divergent aus dem Mikroskopobjektiv 65 aus. Der z-Abstand zwischen der Substratebene 57 und der Bildebene 58 beträgt 1.933 mm. Der Objekt-Bild-Versatz beträgt 477 mm. 21,5 % der in den Pupillenebenen ausgeleuchteten Flächen sind obskuriert. Das Mikroskopobjektiv 65 hat einen Wellenfrontfehler (rms) in Einheiten der Wellenlänge des Beleuchtungslichts 3 von 0,004. Der Hauptstrahlwinkel am zentralen Objektfeldpunkt beträgt 13,8°. Der Spiegel M1 hat eine Größe (x/y) von 219 x 216 mm$^2$. Der Spiegel M2 hat eine Größe von 520 x 502 mm$^2$. Der Spiegel M3 hat eine Größe von 202 x 189 mm$^2$. Der Spiegel M4 hat eine Größe von 742 x 699 mm$^2$. Die Abfolge der Hauptstrahl-Einfallswinkel des Hauptstrahls 26 des zentralen Objektfeldpunktes auf den Spiegeln M1 bis M4 beträgt 10,48°, 3,53°, 0,04° und 0,02°. Die Abfolge der maximalen Einfallswinkel auf den Spiegeln M1 bis M4 beträgt 15,70°, 5,58°, 27,79° und 3,19°. Die Abfolge der Bandbreiten der Einfallswinkel auf den Spiegeln M1 bis M4 beträgt 11,93°, 4,46°, 27,79° und 3,19°. Der Arbeitsabstand in der Mikroskop-Bildebene 58 beträgt 240 mm. Der Arbeitsabstand in der Substratebene 57 beträgt 40 mm. Das Verhältnis zwischen dem Abstand der Mikroskop-Bildebene 58 zum Spiegel M1 und dem Abstand der Mikroskop-Bildebene 58 zum Spiegel M2 beträgt 5,63. Der Abstand zwischen der Substratebene 57 und dem Spiegel M1 sowie die Abstände zwischen den Spiegelpaaren M1 - M2 und M2 - M3 sind größer als 40 % des Abstandes zwischen der Substratebene 57 und der Bildebene 58.

Die optischen Designdaten der Reflexionsflächen der Spiegel M1 bis M4 des Mikroskopobjektivs 65 können den nachfolgenden Tabellen entnommen werden, die den Tabellen zu den vorstehend beschriebenen Projektionsoptiken entsprechen. "Object" bezeichnet hierbei die Mikroskop-Bildebene 58. "Image" bezeichnet die Substratebene 57.

| Surface | Radius | Thickness | Mode |
|---|---|---|---|
| Object | INFINITY | 1350,229 | |
| Mirror 1 | 240,546 | -1110,493 | REFL |
| Mirror 2 | 435,560 | 1653,485 | REFL |
| Mirror 3 | 756,829 | -422,992 | REFL |
| Mirror 4 | 530,970 | 462,991 | REFL |
| Image | INFINITY | 0,000 | |

| Coefficient | M1 | M2 | M3 | M4 |
|---|---|---|---|---|
| K | -1,387402E+00 | -9,186277E-01 | 2,479623E+01 | 1,846234E-01 |
| Y | 0,000000E+00 | 0,000000E+00 | 0,000000E+00 | 0,000000E+00 |
| X2 | -1,972513E-03 | -8,152652E-04 | 4,304599E-04 | 3,443510E-05 |
| Y2 | -2,046135E-03 | -8,219532E-04 | 4,280214E-04 | 3,442623E-05 |
| X2Y | 4,924422E-07 | 1,043274E-08 | 1,420911 E-07 | -1,467857E-09 |
| Y3 | 3,892760E-07 | 1,233789E-08 | 1,433179E-07 | -1,285787E-09 |

(fortgesetzt)

| Coefficient | M1 | M2 | M3 | M4 |
|---|---|---|---|---|
| X4 | 2,843271 E-09 | -8,849537E-11 | 5,644150E-09 | 5,790124E-12 |
| X2Y2 | 6,307229E-09 | -1,868473E-10 | 1,095525E-08 | 1,192799E-11 |
| Y4 | 3,357640E-09 | -9,886660E-11 | 5,323173E-09 | 6,015673E-12 |
| X4Y | 3,303637E-13 | 1,821786E-14 | -9,065558E-13 | 2,636707E-15 |
| X2Y3 | 4,517153E-13 | 3,654773E-14 | -1,999032E-12 | 4,573973E-15 |
| Y5 | -1,472281 E-14 | 1,913697E-14 | -1,039223E-12 | 1,907361 E-15 |
| X6 | -1,567647E-14 | -2,778349E-17 | 3,227077E-14 | 6,941174E-18 |
| X4Y2 | -4,271994E-14 | -8,658416E-17 | 9,037002E-14 | 1,569376E-17 |
| X2Y4 | -3,766656E-14 | -8,931045E-17 | 8,435334E-14 | 1,111043E-17 |
| Y6 | -1,062731 E-14 | -3,096033E-17 | 2,620546E-14 | 2,369368E-18 |
| X6Y | 0,000000E+00 | 0,000000E+00 | 0,000000E+00 | 0,000000E+00 |
| X4Y3 | 0,000000E+00 | 0,000000E+00 | 0,000000E+00 | 0,000000E+00 |
| X2Y5 | 0,000000E+00 | 0,000000E+00 | 0,000000E+00 | 0,000000E+00 |
| Y7 | 0,000000E+00 | 0,000000E+00 | 0,000000E+00 | 0,000000E+00 |
| X8 | 0,000000E+00 | 0,000000E+00 | 0,000000E+00 | 0,000000E+00 |
| X6Y2 | 0,000000E+00 | 0,000000E+00 | 0,000000E+00 | 0,000000E+00 |
| X4Y4 | 0,000000E+00 | 0,000000E+00 | 0,000000E+00 | 0,000000E+00 |
| X2Y6 | 0,000000E+00 | 0,000000E+00 | 0,000000E+00 | 0,000000E+00 |
| Y8 | 0,000000E+00 | 0,000000E+00 | 0,000000E+00 | 0,000000E+00 |
| X8Y | 0,000000E+00 | 0,000000E+00 | 0,000000E+00 | 0,000000E+00 |
| X6Y3 | 0,000000E+00 | 0,000000E+00 | 0,000000E+00 | 0,000000E+00 |
| X4Y5 | 0,000000E+00 | 0,000000E+00 | 0,000000E+00 | 0,000000E+00 |
| X2Y7 | 0,000000E+00 | 0,000000E+00 | 0,000000E+00 | 0,000000E+00 |
| Y9 | 0,000000E+00 | 0,000000E+00 | 0,000000E+00 | 0,000000E+00 |
| X10 | 0,000000E+00 | 0,000000E+00 | 0,000000E+00 | 0,000000E+00 |
| X8Y2 | 0,000000E+00 | 0,000000E+00 | 0,000000E+00 | 0,000000E+00 |
| X6Y4 | 0,000000E+00 | 0,000000E+00 | 0,000000E+00 | 0,000000E+00 |
| X4Y6 | 0,000000E+00 | 0,000000E+00 | 0,000000E+00 | 0,000000E+00 |
| X2Y8 | 0,000000E+00 | 0,000000E+00 | 0,000000E+00 | 0,000000E+00 |
| Y10 | 0,000000E+00 | 0,000000E+00 | 0,000000E+00 | 0,000000E+00 |
| Nradius | 1,000000E+00 | 1,000000E+00 | 1,000000E+00 | 1,000000E+00 |

| Coefficient | M1 | M2 | M3 | M4 |
|---|---|---|---|---|
| Y-decenter | -419,012 | -607,162 | -478,467 | -476,646 |
| X-rotation | -2,721 | 8,467 | 0,209 | -0,024 |

Die optischen Daten des zweiten Mikroskopobjektivs 66, das in der Fig. 17 dargestellt ist und ebenfalls anstelle des Mikroskopobjektivs 56 nach Fig. 13 zum Einsatz kommen kann, werden nachfolgend zusammengefasst:

Die objektseitige numerische Apertur NA beträgt 0,8. Die Größe des quadratischen Objektfeldes beträgt 0,8 x 0,8 mm$^2$. Der vergrößernde Abbildungsmaßstab beträgt 40x. Die Wellenlänge des Beleuchtungslichts 3 beträgt 193,0 nm. Auch andere Beleuchtungslicht-Wellenlängen, zum Beispiel sichtbare oder EUV-Wellenlängen können zum Einsatz kommen. Die Abfolge der optischen Wirkungen der Spiegel M 1 bis M4 (negativ N; positiv P) ist NPNP. Das einzige Zwischenbild liegt zwischen den Spiegeln M2 und M3 im Bereich der Durchgangsbohrung 23 im Spiegel M4. Hauptstrahlen laufen bildseitig divergent aus dem Mikroskopobjektiv 66 aus. Der z-Abstand zwischen der Substratebene 57 und der Bildebene 58 beträgt 2.048 mm. Der Objekt-Bild-Versatz beträgt 522 mm. 24,6 % der in den Pupillenebenen ausgeleuchteten Flächen sind obskuriert. Das Mikroskopobjektiv 66 hat einen Wellenfrontfehler (rms) in Einheiten der Wellenlänge des Beleuchtungslichts 3 von 0,016. Der Hauptstrahlwinkel am zentralen Objektfeldpunkt beträgt 17,1°. Der Spiegel M1 hat eine Größe (x/y) von 59 x 58 mm$^2$. Der Spiegel M2 hat eine Größe von 222 x 197 mm$^2$. Der Spiegel M3 hat eine Größe von 180 x 163 mm$^2$. Der Spiegel M4 hat eine Größe von 736 x 674 mm$^2$. Die Abfolge der Hauptstrahl-Einfallswinkel des Hauptstrahls 26 des zentralen Objektfeldpunktes auf den Spiegeln M1 bis M4 beträgt 12,23°, 3,81°, 0,10° und 0,14°. Die Abfolge der maximalen Einfallswinkel auf den Spiegeln M1 bis M4 beträgt 18,94°, 5,66°, 24,95° und 2,75°. Die Abfolge der Bandbreiten der Einfallswinkel auf den Spiegeln M1 bis M4 beträgt 10,17°, 1,81°, 24,95° und 2,75°. Der Arbeitsabstand in der Mikroskop-Bildebene 58 beträgt 996 mm. Der Arbeitsabstand in der Substratebene 57 beträgt 40 mm. Das Verhältnis zwischen dem Abstand der Mikroskop-Bildebene 58 zum Spiegel M1 und dem Abstand der Mikroskop-Bildebene 58 zum Spiegel M2 beträgt 1,46. Der Abstand zwischen der Substratebene 57 und dem Spiegel M1 sowie der Abstand zwischen dem Spiegelpaar M2 - M3 ist kleiner als 40 % des Abstandes der Substratebene 57 zur Bildebene 58.

Die optischen Designdaten der Reflexionsflächen der Spiegel M1 bis M4 des Mikroskopobjektivs 66 können den nachfolgenden Tabellen entnommen werden, die den Tabellen zum vorstehend beschriebenen Mikroskopobjektiv 65 entsprechen.

| Surface | Radius | Thickness | Mode |
|---------|--------|-----------|------|
| Object | INFINITY | 1458,431 | |
| Mirror 1 | 138,358 | -462,391 | REFL |
| Mirror 2 | 352,350 | 1011,807 | REFL |
| Mirror 3 | 521,060 | -429,417 | REFL |
| Mirror 4 | 523,773 | 469,415 | REFL |
| Image | INFINITY | 0,000 | |

| Coefficient | M1 | M2 | M3 | M4 |
|-------------|-----|-----|-----|-----|
| K | 2,186021E-01 | -8,967130E-01 | 1,353344E+01 | 1,426428E-01 |
| Y | 0,000000E+00 | 0,000000E+00 | 0,000000E+00 | 0,000000E+00 |
| X2 | -2,119566E-03 | -6,122040E-04 | 3,598902E-04 | 2,150055E-05 |
| Y2 | -1,870353E-03 | -6,339662E-04 | 4,023778E-04 | 2,187467E-05 |
| X2Y | -2,390768E-05 | 6,494155E-08 | -2,453628E-07 | 3,235225E-09 |
| Y3 | -2,981028E-05 | 5.78021 OE-08 | -6,744637E-08 | 4,604016E-09 |
| X4 | 1,923306E-08 | 2,795937E-10 | 2,925492E-09 | -1,313710E-12 |
| X2Y2 | 4,121148E-07 | 5,095698E-10 | 1,819466E-09 | -5,092789E-12 |
| Y4 | 4,757534E-07 | 2,387275E-10 | -6,547683E-10 | -2,809211 E-12 |
| X4Y | -1,446899E-09 | 5,301791E-13 | -9,735433E-12 | -3,703196E-15 |
| X2Y3 | -7,970490E-09 | 8,235778E-13 | -4,591548E-11 | -1,311139E-14 |
| Y5 | -6,911626E-09 | 5,427574E-13 | -3,434264E-11 | -8,056144E-15 |
| X6 | -6,957804E-12 | 4,031055E-16 | 4,869018E-14 | -2,032419E-18 |
| X4Y2 | -6,520224E-12 | 3,388642E-15 | 1,730353E-13 | -5,277652E-18 |
| X2Y4 | 5,785767E-11 | 4,106532E-15 | 8,768509E-14 | -5,976002E-18 |
| Y6 | 5,002226E-11 | -2,665419E-15 | -1,533312E-14 | 3,256782E-19 |
| X6Y | 3,978450E-14 | -3,458637E-18 | 2,808257E-16 | -2,974086E-21 |
| X4Y3 | 1,060921 E-15 | -5,135846E-18 | 1,062927E-15 | -1,985462E-20 |
| X2Y5 | -2,907745E-13 | 1,367522E-17 | 1,248668E-15 | -1,673351 E-20 |
| Y7 | -1,895272E-13 | 2,948597E-17 | 4,722358E-16 | -2,273773E-22 |
| X8 | 0,000000E+00 | 9,742461 E-21 | -1,224565E-19 | -5,498909E-24 |
| X6Y2 | 0,000000E+00 | -1,149790E-22 | -8,469691E-19 | -3,121995E-23 |
| X4Y4 | 0,000000E+00 | -3,605842E-20 | -9,612391 E-19 | -9,354588E-23 |
| X2Y6 | 0,000000E+00 | -8,956173E-20 | 3,862422E-20 | -1,029099E-22 |
| Y8 | 0,000000E+00 | -6,962503E-20 | 1,096441E-19 | -3,729022E-23 |
| X8Y | 0,000000E+00 | 0,000000E+00 | 0,000000E+00 | 0,000000E+00 |
| X6Y3 | 0,000000E+00 | 0,000000E+00 | 0,000000E+00 | 0,000000E+00 |
| X4Y5 | 0,000000E+00 | 0,000000E+00 | 0,000000E+00 | 0,000000E+00 |
| X2Y7 | 0,000000E+00 | 0,000000E+00 | 0,000000E+00 | 0,000000E+00 |
| Y9 | 0,000000E+00 | 0,000000E+00 | 0,000000E+00 | 0,000000E+00 |

(fortgesetzt)

| Coefficient | M1 | M2 | M3 | M4 |
|---|---|---|---|---|
| X10 | 0,000000E+00 | 0,000000E+00 | 0,000000E+00 | 0,000000E+00 |
| X8Y2 | 0,000000E+00 | 0,000000E+00 | 0,000000E+00 | 0,000000E+00 |
| X6Y4 | 0,000000E+00 | 0,000000E+00 | 0,000000E+00 | 0,000000E+00 |
| X4Y6 | 0,000000E+00 | 0,000000E+00 | 0,000000E+00 | 0,000000E+00 |
| X2Y8 | 0,000000E+00 | 0,000000E+00 | 0,000000E+00 | 0,000000E+00 |
| Y10 | 0,000000E+00 | 0,000000E+00 | 0,000000E+00 | 0,000000E+00 |
| Nradius | 1,000000E+00 | 1,000000E+00 | 0,000000E+00 | 0,000000E+00 |

| Coefficient | M1 | M2 | M3 | M4 |
|---|---|---|---|---|
| Y-decenter | -473,594 | -625,447 | -517,418 | -517,782 |
| X-rotation | -2,590 | 13,500 | -1,408 | -0,608 |

**Patentansprüche**

1. Abbildende Optik (6; 35; 42; 49; 56; 63; 64; 65; 66) mit einer Mehrzahl von Spiegeln (M1 bis M6; 59 bis 62), die ein Objektfeld in einer Objektebene (4; 58) in ein Bildfeld (7) in einer Bildebene (8; 57) abbilden, wobei mindestens einer der Spiegel (M6; 62) eine Durchgangsöffnung (23) zum Durchtritt von Abbildungslicht (3) aufweist, **dadurch gekennzeichnet, dass** eine Reflexionsfläche mindestens eines Spiegels (M1 bis M6; 59 bis 62) als nicht durch eine rotationssymmetrische Funktion beschreibbare Freiformfläche (27) ausgeführt ist.

2. Abbildende Optik nach Anspruch 1, **dadurch gekennzeichnet, dass** die Bildebene (8; 57) parallel zur Objektebene (4; 58) angeordnet ist.

3. Abbildende Optik nach Anspruch 1 oder 2, **dadurch gekennzeichnet, dass** das Abbildungslicht (3) von den Spiegeln (M1 bis M6; 59 bis 62) mit einem maximalen Reflexionswinkel von 25°, bevorzugt mit einem maximalen Reflexionswinkel von 20°, mehr bevorzugt mit einem maximalen Reflexionswinkel von 16°, reflektiert wird.

4. Abbildende Optik nach Anspruch 3, **dadurch gekennzeichnet, dass** der Quotient aus einem maximalen Reflexionswinkel ($\alpha$) des Abbildungslichts (3) innerhalb der abbildenden Optik (6; 35; 42; 49; 56) und ihrer bildseitigen numerischen Apertur maximal 40° beträgt.

5. Abbildende Optik nach einem der Ansprüche 1 bis 4, **dadurch gekennzeichnet, dass** ein im Abbildungsstrahlengang vor dem letzten Spiegel (M6; 62) im Bereich einer Pupillenebene (21) angeordneter Spiegel (M3; 59) eine konvexe Grundform aufweist.

6. Abbildende Optik nach einem der Ansprüche 1 bis 5, **gekennzeichnet durch** mindestens vier Spiegel (M1 bis M6; 59 bis 62), insbesondere **durch** sechs Spiegel (M1 bis M6).

7. Abbildende Optik nach einem der Ansprüche 1 bis 6, **dadurch gekennzeichnet, dass** mindestens zwei der Spiegel (M1, M3 ; M1, M2, M3) eine negative Hauptstrahlwinkelvergrößerung haben.

8. Abbildende Optik nach Anspruch 7, **dadurch gekennzeichnet, dass** zwischen zwei Spiegeln (M1, M3) mit negativer Hauptstrahlwinkelvergrößerung ein Spiegel (M2) mit positiver Hauptstrahlwinkelvergrößerung angeordnet ist.

9. Abbildende Optik nach einem der Ansprüche 1 bis 8, **dadurch gekennzeichnet, dass** der durch den letzten Spiegel (M6; 62) und zentral durch eine Pupille geführte Abbildungsstrahl eines zentralen Objektpunktes einen Winkel zur Bildebene (8; 57) einschließt, der größer ist als 85°.

10. Abbildende Optik nach einem der Ansprüche 1 bis 9, **dadurch gekennzeichnet, dass** der durch den letzten Spiegel (M6; 62) geführte Abbildungsstrahlengang im Bereich von dessen Durchgangsöffnung (23) in einer Zwischenbildebene (22) ein Zwischenbild hat, wobei eine Teil-Optik (M1 bis M4; 59, 60) zwischen der Objektebene (4; 58) und der Zwischenbildebene (22) einen verkleinernden Abbildungsmaßstab von mindestens 2x hat.

11. Abbildende Optik nach einem der Ansprüche 1 bis 10, **dadurch gekennzeichnet, dass** ein im Abbildungsstrahlengang vorletzter Spiegel (M5; 61), von dem aus Abbildungslicht zum letzten Spiegel (M6; 62) reflektiert wird, eine Durchgangsöffnung (24) zum Durchtritt des Abbildungslichts aufweist, wobei das Bildfeld (7) um nicht mehr als um ein Fünftel des Durchmessers des vorletzten Spiegels (M5) relativ zu diesem vorletzten Spiegel (M5) dezentriert, insbesondere zentrisch, hinter dem vorletzten Spiegel (M5) angeordnet ist.

12. Abbildende Optik nach Anspruch 11, **dadurch gekennzeichnet, dass** der im Abbildungsstrahlengang vorletzte Spiegel (M5; 61) einen Krümmungsradius aufweist, dessen Betrag größer ist als 500 mm, bevorzugt größer ist als 1.000 mm, noch mehr bevorzugt größer ist als 1.500 mm.

13. Abbildende Optik nach einem der Ansprüche 1 bis 12, **dadurch gekennzeichnet, dass** sie ein Bildfeld (7) ausleuchtet, das größer ist als 1 mm$^2$.

14. Abbildende Optik nach einem der Ansprüche 1 bis 13, **gekennzeichnet durch** eine bildseitige numerischen Apertur von mindestens 0,4, bevorzugt von mindestens 0,45, noch mehr bevorzugt von mindestens 0,5, noch mehr bevorzugt von mindestens 0,55, noch mehr bevorzugt von mindestens 0,6, noch mehr bevorzugt von mindestens 0,65, noch mehr bevorzugt von mindestens 0,7.

15. Abbildende Optik nach einem der Ansprüche 1 bis 14, **dadurch gekennzeichnet, dass** sie bildseitig telezentrisch ist.

16. Abbildende Optik nach einem der Ansprüche 1 bis 15, **gekennzeichnet durch** einen Objekt-Bild-Versatz ($d_{ois}$), der geringer ist als 100 mm, bevorzugt geringer ist als 10 mm, noch mehr bevorzugt geringer ist als 1 mm.

17. Abbildende Optik nach einem der Ansprüche 1 bis 16, **gekennzeichnet durch** mindestens ein Paar benachbarter Spiegel (M2, M3; M3, M4; M4, M5; M5, M6), die senkrecht zur Objektebene (4; 58) und/oder zur Bildebene (8; 57) einen Abstand zueinander haben, der größer ist als 40 % des Abstandes des Objektfeldes zum Bildfeld.

18. Abbildende Optik nach einem der Ansprüche 1 bis 17, **dadurch gekennzeichnet, dass** mindestens ein Spiegel (M1 bis M4; M1, M4) einen minimalen Abstand der genutzten Reflexionsfläche zum nächstliegenden, diesen Spiegel nicht beaufschlagenden Abbildungsstrahlengang hat, der kleiner ist als 25 mm.

19. Abbildende Optik nach einem der Ansprüche 1 bis 18, **dadurch gekennzeichnet, dass** der Spiegel (M6; 62) der die Durchgangsöffnung (23) zum Durchtritt des Abbildungslichts (3) aufweist, der im Abbildungsstrahlengang letzte Spiegel ist, von dem aus das Abbildungslicht (3) hin zum Bildfeld (7) reflektiert wird.

20. Projektionsbelichtungsanlage für die Mikrolithografie

- mit einer abbildenden Optik (6; 35; 42; 49) nach einem der Ansprüche 1 bis 19,
- mit einer Lichtquelle (2) für das Beleuchtungs- und Abbildungslicht (3),
- mit einer Beleuchtungsoptik (5) zur Führung des Beleuchtungslichts (3) hin zum Objektfeld der abbildenden Optik (6; 35; 42; 49).

21. Projektionsbelichtungsanlage nach Anspruch 20, **dadurch gekennzeichnet, dass** die Lichtquelle (2) zur Erzeugung von Beleuchtungslicht (3) mit einer Wellenlänge zwischen 10 und 30 nm ausgebildet ist.

22. Verfahren zur Herstellung eines mikrostrukturierten Bauteils mit folgenden Verfahrensschritten:

- Bereitstellen eines Retikels (9) und eines Wafers (10),
- Projizieren einer Struktur auf dem Retikel (9) auf eine lichtempfindliche Schicht des Wafers (10) mit Hilfe der Proj ektionsbelichtungsanlage nach Anspruch 20 oder 21,
- Erzeugung einer Mikrostruktur auf dem Wafer (10).

23. Mikrostrukturiertes Bauelement, hergestellt nach einem Verfahren nach Anspruch 22.

24. Verwendung einer abbildenden Optik als Mikroskopobjektiv (56), wobei die Anordnung der optischen Komponenten bei dieser Verwendung derjenigen nach einem der Ansprüche 1 bis 19 mit der Maßgabe entspricht, dass Objekt- und Bildebene vertauscht sind.

25. Verwendung nach Anspruch 24 bei der Inspektion eines im Rahmen der Projektionsbelichtung mit einer lithografischen Projektionsbelichtungsanlage zu belichtenden oder belichteten Substrats (10).

Fig. 1

Fig. 2

Fig. 3

Fig. 4

Fig. 5

Fig. 6

Fig. 7

**Fig. 8**

**Fig. 9**

Fig. 10

EP 1 950 594 A1

Fig. 11

EP 1 950 594 A1

Fig. 12

EP 1 950 594 A1

Fig. 13

Fig. 14

EP 1 950 594 A1

Fig. 15

EP 1 950 594 A1

Fig. 16

Fig. 17

**Europäisches Patentamt**

**EUROPÄISCHER RECHERCHENBERICHT**

Nummer der Anmeldung

EP 08 00 0196

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| D,Y | DE 10 2005 042005 A1 (ZEISS CARL SMT AG [DE]) 6. Juli 2006 (2006-07-06) * das ganze Dokument * ----- | 1-25 | INV. G02B17/06 G03F7/20 G02B27/00 |
| D,Y | EP 1 093 021 A (NIPPON KOGAKU KK [JP]) 18. April 2001 (2001-04-18) * das ganze Dokument * ----- | 1-25 | |
| Y | US 6 213 610 B1 (TAKAHASHI TOMOWAKI [JP] ET AL) 10. April 2001 (2001-04-10) * Spalte 12, Zeile 42 - Zeile 49; Abbildungen 1-12 * ----- | 1-25 | |
| Y | WO 2006/046507 A (NIPPON KOGAKU KK [JP]; ISHIKAWA MITSUO [JP]) 4. Mai 2006 (2006-05-04) * das ganze Dokument * ----- | 1-25 | |

RECHERCHIERTE SACHGEBIETE (IPC)

G02B
G03F

Der vorliegende Recherchenbericht wurde für alle Patentansprüche erstellt

| Recherchenort | Abschlußdatum der Recherche | Prüfer |
|---|---|---|
| München | 1. April 2008 | Daffner, Michael |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 08 00 0196

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

01-04-2008

| Im Recherchenbericht angeführtes Patentdokument | Datum der Veröffentlichung | Mitglied(er) der Patentfamilie | Datum der Veröffentlichung |
|---|---|---|---|
| DE 102005042005 A1 | 06-07-2006 | KEINE | |
| EP 1093021 A | 18-04-2001 | KEINE | |
| US 6213610 B1 | 10-04-2001 | KEINE | |
| WO 2006046507 A | 04-05-2006 | CN 101048690 A<br>EP 1806610 A1<br>KR 20070063503 A<br>US 2008055756 A1 | 03-10-2007<br>11-07-2007<br>19-06-2007<br>06-03-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1093021 A2
- DE 102005042005 A1
- US 20060284113 A1
- US 6894834 B2
- US 6000798 A
- WO 0188597 A